(19) Europäisches Patentamt
European Patent Office
Office européen des brevets

(11) **EP 4 664 511 A1**

(12) **EUROPEAN PATENT APPLICATION**

(43) Date of publication:
**17.12.2025  Bulletin 2025/51**

(21) Application number: **25175403.2**

(22) Date of filing: **09.05.2025**

(51) International Patent Classification (IPC):
*H01L 21/78* (2006.01)       *H01L 21/302* (2006.01)
*B23K 26/03* (2006.01)       *B23K 26/364* (2014.01)
*H01L 21/67* (2006.01)

(52) Cooperative Patent Classification (CPC):
**H01L 21/78; B23K 26/032; B23K 26/364;**
**H01L 21/67242;** H01L 21/302

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority: **13.06.2024  US 202463659441 P**
**15.01.2025  US 202519021938**
**15.01.2025  US 202519022139**

(71) Applicant: **Deuvtek Co., Ltd.**
**New Taipei City  23551 (TW)**

(72) Inventors:
• **CHANG, Paichun**
**23551 New Taipei City (TW)**
• **CHYAN, Jiunn-Yih**
**23551 New Taipei City (TW)**

(74) Representative: **Banse & Steglich**
**Patentanwälte PartmbB**
**Patentanwaltskanzlei**
**Herzog-Heinrich-Straße 23**
**80336 München (DE)**

(54) **SYSTEM FOR LOCALIZED WAFER THINNING AND METHOD THEREOF**

(57)      A method for localized wafer thinning, comprising following steps of: providing a wafer including a plurality of dies; for each of the plurality of dies, determining at least one interested feature related to at least one device formed on a top surface of the wafer and at least one to-be-thinned starting region according to the at least one interested feature; capturing at least one image of each of the plurality of dies; performing image recognition on the at least one image to recognize the at least one interested feature of each of the plurality of die; and performing localized laser thinning processing on a bottom surface of the wafer within the at least one to-be-thinned starting region of each of the plurality of dies, such that the wafer is locally thinned.

Fig. 1

EP 4 664 511 A1

**Description**

**Field of the invention**

The present invention relates to a system and method for localized wafer thinning, in particular to a system and method for localized wafer thinning using a laser process.

**Background of the invention**

Conventional technology often uses grinding methods to thin the entire backside of the wafer. When the wafer is thinned to a thickness that is too thin, especially when the thickness of the wafer is smaller than 100μm, the wafer can easily bend and warp. Especially in fields such as VCSEL (Vertical-Cavity Surface-Emitting Laser), many epitaxial layers are formed on the front side of the wafer, these epitaxial layers cause the wafer to accumulate a lot of stress. Once the wafer is thinned too thin, the degree of wafer warpage will be very serious. This will make the wafer difficult to handle. And it is difficult to carry out subsequent processes on the wafer. Moreover, using conventional grinding methods to thin the entire backside of the wafer, the breakage ratio is usually quite high. For example, when thinning SiC wafer for the power devices, such as SiC MOSFET (Metal-Oxide-Semiconductor Field-Effect Transistor) @1200V-6500V, the SiC wafer needs to be thinned to have a thickness smaller than 150μm; however, the breakage ratio is usually about 3% to 5%. Another example, when thinning SiC wafer for RF devices, sometimes the requirement of the thickness of the thinned SiC wafer needs to be smaller than 100μm; however, the breakage ratio will be higher than 5%. On the other hand, the conventional grinding methods cost a lot.

Another conventional technology attempts to solve the problem of warpage caused by wafer thinning. This conventional technology uses a smaller grinding wheel with a diameter smaller than a diameter of the wafer to grind the backside of the wafer to thin the middle portion of the backside of the wafer. Only the ring-shaped frame at the edge of the wafer is left without being thinned by grinding. Although the ring-shaped frame at the edge of the wafer can reduce the degree of wafer warpage, when the middle portion of the backside of the wafer is thinned to too thin, the supporting stress in the middle portion of the wafer will still be insufficient or the wafer warpage will still occur.

**Summary of the invention**

The main technical problem that the present invention is seeking to solve is how to provide a system and method for thinning the wafer, especially thinning the wafer locally, so that after the wafer is thinned, the wafer will not warp.

In order to solve the above described problems and to achieve the expected effect, the present invention provides a method for localized wafer thinning, which comprises following steps of: Step A: providing a wafer, wherein the wafer includes a plurality of dies, each of the plurality of dies includes at least one device formed on a top surface of the wafer; Step B: determining at least one interested feature of each of the plurality of dies, wherein the at least one interested feature of each of the plurality of dies is related to the at least one device of each of the plurality of dies respectively; Step C: determining at least one to-be-thinned starting region of each of the plurality of dies according to the at least one interested feature of each of the plurality of dies respectively; Step D: capturing at least one image of each of the plurality of dies by an image capturing apparatus; Step E: performing image recognition on the at least one image to recognize the at least one interested feature of each of the plurality of dies by an image recognition device; and Step F: performing localized laser thinning processing on a bottom surface of the wafer within the at least one to-be-thinned starting region of each of the plurality of dies by a laser apparatus, such that the wafer is locally thinned within the at least one to-be-thinned starting region of each of the plurality of dies.

Furthermore, the present invention also provide a system for localized wafer thinning, which comprises a motion driving apparatus, a carrying apparatus, an image capturing apparatus, a controlling integration apparatus and a laser apparatus. The carrying apparatus is disposed on the motion driving apparatus. The carrying apparatus is used for carrying a wafer. The wafer includes a plurality of dies. Each of the plurality of dies includes at least one device formed on a top surface of the wafer. The image capturing apparatus includes an image capture device. The motion driving apparatus enables at least one of a relative displacement and a relative rotation between the image capture device and the wafer. The image capture device is used for capturing at least one image of each of the plurality of dies. The controlling integration apparatus is connected to the motion driving apparatus, the carrying apparatus, the image capturing apparatus and the laser apparatus for controlling the motion driving apparatus, the carrying apparatus, the image capturing apparatus and the laser apparatus. The controlling integration apparatus is used for determining at least one interested feature of each of the plurality of dies and determining at least one to-be-thinned starting region of each of the plurality of dies according to the at least one interested feature of each of the plurality of dies respectively. The at least one interested feature of each of the plurality of dies is related to the at least one device of each of the plurality of dies respectively. The controlling integration apparatus includes an image recognition device. The image recognition device is used for performing image recognition on the at least one image of each of the plurality of dies captured by the image capture device to recognize the at least one interested feature of each of the plurality of dies. The motion driving apparatus enables at least one of a relative displacement and a relative rotation between the laser apparatus and the wafer. The laser apparatus is used for performing localized laser thinning processing on a bottom surface of the wafer within the at least one to-be-thinned starting region of each of the plurality of dies, such that the wafer is locally thinned within the at least one to-be-thinned starting region of each of the plurality of dies.

In implementation, the method further comprises a following step of: determining at least one interested region of each of the plurality of dies according to the at least one interested feature of each of the plurality of dies respectively, wherein the at least one interested region of each of the plurality of dies is within or identical to the at least one to-be-thinned starting region of each of the plurality of dies respectively.

In implementation, the controlling integration apparatus is further used for determining at least one interested region of each of the plurality of dies according to the at least one interested feature of each of the plurality of dies respectively, wherein the at least one interested region of each of the plurality of dies is within or identical to the at least one to-be-thinned starting region of each of the plurality of dies respectively.

In implementation, at least one backside trench of each of the plurality of dies is formed after performing localized laser thinning processing, the at least one interested region of each of the plurality of dies defines a region occupied by a bottom surface of the at least one backside trench of each of the plurality of dies respectively.

In implementation, the wafer has a desired thickness within at least one of the at least one interested region of each of the plurality of dies respectively after performing localized laser thinning processing.

In implementation, after performing localized laser thinning processing, the wafer has a desired thickness D within one of the at least one interested region of each of the plurality of dies respectively; while the wafer has a desired thickness D' within the other one of the at least one interested region of each of the plurality of dies respectively, wherein the desired thickness D is smaller than, equal to or greater than the desired thickness D'.

In implementation, the at least one interested feature of each of the plurality of dies is within or identical to the at least one interested region of each of the plurality of dies respectively.

In implementation, in each of the plurality of dies, the at least one interested region includes a first interested sub-region and a second interested sub-region; wherein, in each of the plurality of dies, after performing localized laser thinning processing, the wafer has a desired thickness D1 within the first interested sub-region of the at least one interested region respectively; while the wafer has a desired thickness D2 within the second interested sub-region of the at least one interested region respectively, wherein the desired thickness D1 is equal to or greater than the desired thickness D2, wherein the desired thickness D2 is greater than 100nm.

In implementation, each of the plurality of dies includes a plurality of sub-dies, each of the plurality of sub-dies includes at least one of the at least one device formed on the top surface of the wafer.

In implementation, the at least one interested feature of each of the plurality of dies is within or identical to the at least one to-be-thinned starting region of each of the plurality of dies respectively.

In implementation, in each of the plurality of dies, one of the at least one to-be-thinned starting region and the other one of the at least one to-be-thinned starting region are adjacent, wherein, in each of the plurality of dies, a gap between the one of the at least one to-be-thinned starting region and the other one of the at least one to-be-thinned starting region is greater than or equal to 10$\mu$m.

In implementation, the wafer is not transparent, the top surface of the wafer is between the bottom surface of the wafer and the image capturing apparatus.

In implementation, the wafer is transparent, the image capturing apparatus includes an image capture device and a light source, wherein the top surface of the wafer is between the bottom surface of the wafer and the light source, wherein the top surface of the wafer is between the bottom surface of the wafer and the image capture device or the bottom surface of the wafer is between the top surface of the wafer and the image capture device.

In implementation, the wafer is made of at least one material selected from the group consisting of: glass, SiC, GaN, GaN on SiC, Ga2O3, Si, GaN on Si, GaAs, sapphire, InP, GaP, AlN, ZnSe, InAs, SiGe, diamond and GaSb.

For further understanding the characteristics and effects of the present invention, some preferred embodiments referred to drawings are in detail described as follows.

**Brief description of drawings**

Figure 1 is a cross-sectional schematic view of an embodiment of a system for localized wafer thinning of the present invention.
Figure 2 is a schematic view of a top surface of a wafer in Figure 1.
Figure 3 is a partial enlarged view of a region X of Figure 2, in which a schematic view of a top surface of a die is illustrated.

Figure 4 is a schematic view of an embodiment of an interested region and a to-be-thinned starting region on the top surface of the die in Figure 3.

Figure 5 is a schematic view of the interested region and the to-be-thinned starting region on a bottom surface of the die in Figure 4.

Figure 6 is a cross-sectional schematic view taken along the A-A' section line in Figure 5 before the wafer has been locally thinned by localized laser thinning processing of the present invention.

Figure 7 is a cross-sectional schematic view taken along the B-B' section line in Figure 5 before the wafer has been locally thinned by localized laser thinning processing of the present invention.

Figure 8 is a cross-sectional schematic view taken along the A-A' section line in Figure 5 after the wafer has been locally thinned within the to-be-thinned starting region of the die by localized laser thinning processing of the present invention.

Figure 9 is a cross-sectional schematic view taken along the B-B' section line in Figure 5 after the wafer has been locally thinned within the to-be-thinned starting region of the die by localized laser thinning processing of the present invention.

Figure 10 is a perspective schematic view of a bottom surface of the wafer of Figure 5 after the wafer has been locally thinned within the to-be-thinned starting region of the die by localized laser thinning processing of the present invention.

Figure 11 is a cross-sectional schematic view of the die cut from the wafer in Figure 8.

Figure 12 is a schematic view of another embodiment of an interested region and a to-be-thinned starting region on the bottom surface of the die in Figure 3.

Figure 13 is a cross-sectional schematic view taken along the C-C' section line in Figure 12 before the wafer has been locally thinned by localized laser thinning processing of the present invention.

Figure 14 is a cross-sectional schematic view taken along the C-C' section line in Figure 12 after the wafer has been locally thinned within the to-be-thinned starting region of the die by localized laser thinning processing of the present invention.

Figure 15 is a cross-sectional schematic view of another embodiment of an interested region and a to-be-thinned starting region of a die before the wafer has been locally thinned by localized laser thinning processing of the present invention.

Figure 16 is a cross-sectional schematic view of the die in Figure 15 after the wafer has been locally thinned within the to-be-thinned starting region of the die by localized laser thinning processing of the present invention.

Figure 17 is a cross-sectional schematic view of another embodiment of two interested regions and two to-be-thinned starting regions of a die before the wafer has been locally thinned by localized laser thinning processing of the present invention.

Figure 18 is a cross-sectional schematic view of the die in Figure 17 after the wafer has been locally thinned within the to-be-thinned starting region of the die by localized laser thinning processing of the present invention.

Figure 19 is a schematic view of another embodiment of an interested region and a to-be-thinned starting region on the bottom surface of the die in Figure 3.

Figure 20 is a cross-sectional schematic view taken along the D-D' section line in Figure 19 before the wafer has been locally thinned by localized laser thinning processing of the present invention.

Figure 21 is a cross-sectional schematic view taken along the D-D' section line in Figure 19 after the wafer has been locally thinned within the to-be-thinned starting region of the die by localized laser thinning processing of the present invention.

Figure 22 is a perspective schematic view of the bottom surface of the wafer of Figure 19 after the wafer has been locally thinned within the to-be-thinned starting region of the die by localized laser thinning processing of the present invention.

Figure 23 is a cross-sectional schematic view of the die cut from the wafer in Figure 21.

Figure 24 is a cross-sectional schematic view of the wafer taken along the E-E' section line in Figure 22 after the wafer has been locally thinned within the to-be-thinned starting region of the die by localized laser thinning processing of the present invention.

Figure 25 is a cross-sectional schematic view of another embodiment of an interested region and a to-be-thinned starting region of a die before the wafer has been locally thinned by localized laser thinning processing of the present invention.

Figure 26 is a cross-sectional schematic view of the die in Figure 25 after the wafer has been locally thinned within the to-be-thinned starting region of the die by localized laser thinning processing of the present invention.

Figure 27 is a cross-sectional schematic view of another embodiment of an interested region and a to-be-thinned starting region of a die before the wafer has been locally thinned by localized laser thinning processing of the present invention.

Figure 28 is a cross-sectional schematic view of the die in Figure 27 after the wafer has been locally thinned within the to-be-thinned starting region of the die by localized laser thinning processing of the present invention.

Figure 29 is a cross-sectional schematic view of another embodiment of a system for localized wafer thinning of the present invention.

Figure 30 is a cross-sectional schematic view of an embodiment of two dies after the wafer has been locally thinned by localized laser thinning processing of the present invention.

Figure 31 is a schematic partial enlarged view of another embodiment of a bottom surface of a wafer before the wafer has been locally thinned by localized laser thinning processing of the present invention.

Figure 32 is a schematic view of the bottom surface of the wafer in Figure 31 after the wafer has been locally thinned by localized laser thinning processing of the present invention.

Figure 33 is a schematic partial enlarged view of another embodiment of a bottom surface of a wafer after the wafer has been locally thinned by localized laser thinning processing of the present invention.

**Detailed Descriptions of Preferred Embodiments**

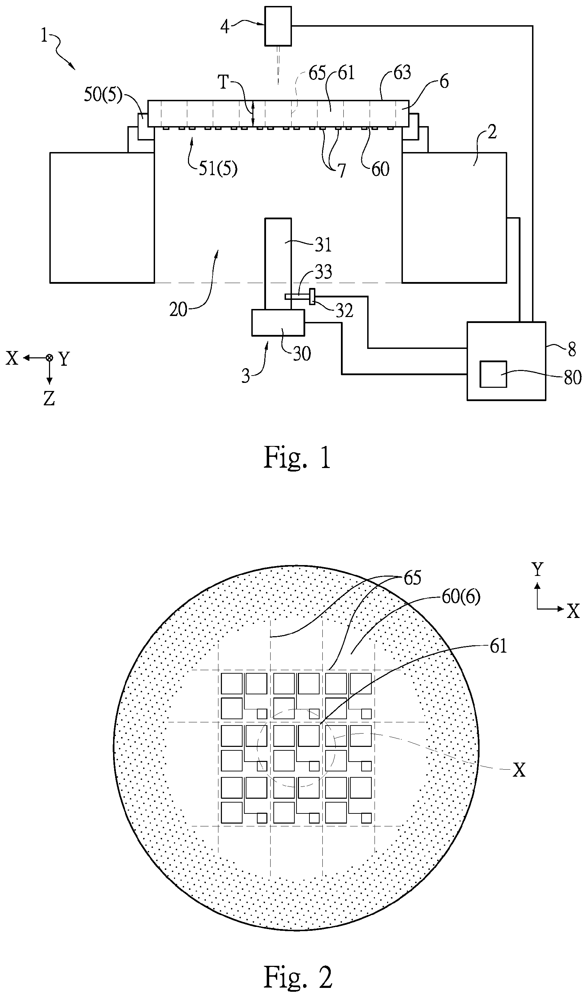

Please refer to Figure 1, which shows a cross-sectional schematic view of an embodiment of a system for localized wafer thinning of the present invention. The system for localized wafer thinning 1 of the present invention comprises a motion driving apparatus 2, an image capturing apparatus 3, a laser apparatus 4, a carrying apparatus 5 and a controlling integration apparatus 8.

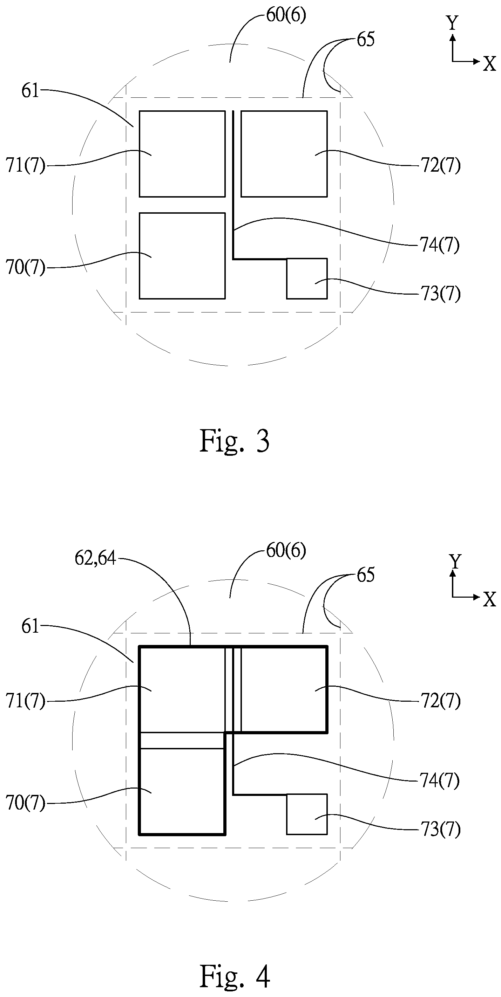

In current embodiment, the carrying apparatus 5 includes a clamping device 50, wherein the carrying apparatus 5 has a hollow center portion 51. The clamping device 50 is surrounding the hollow center portion 51 of the carrying apparatus 5. The clamping device 50 of the carrying apparatus 5 is used for clamping a peripheral edge of a wafer 6, so that the wafer 6 can be carried by the carrying apparatus 5. The carrying apparatus 5 is disposed on the motion driving apparatus 2. In current embodiment, the wafer 6 is carried by the carrying apparatus 5 with a top surface 60 of the wafer 6 facing down (that is, a bottom surface 63 of the wafer 6 is facing up), wherein the wafer 6 includes a plurality of dies 61. Please refer to Figure 2 which shows a schematic view of a top surface of a wafer in Figure 1. Please also refer to Figure 3, which shows a partial enlarged view of a region X of Figure 2, in which a schematic view of a top surface of a die is illustrated. In current embodiment, each of the plurality of dies 61 includes only one device 7 (in general, each of the plurality of dies 61 may include at least one device 7, and/or some other devices, and/or an integrated circuit). In current embodiment, the device 7 is a power device (for example, a power MOSFET). The device 7 includes a first source electrode 70, a second source electrode 71, a third source electrode 72, a gate electrode 73 and a gate finger 74, wherein the first source electrode 70, the second source electrode 71, the third source electrode 72, the gate electrode 73 and the gate finger 74 are formed on the top surface 60 of the wafer 6, wherein the gate finger 74 has a very thin shape comparing to a shape of each of the three source electrodes 70, 71, 72. The device 7 may further include a drain electrode; however, in current embodiment, the drain electrode of the device 7 has not been formed yet. Therefore, the drain electrode of the device 7 is not shown in Figure.

In current embodiment, an X-axis direction, a Y-axis direction and a Z-axis direction are shown in Figures 1-3, wherein the Y-axis direction is perpendicular to the X-axis direction and also perpendicular to the Z-axis direction, and the X-axis direction is perpendicular to the Z-axis direction. In current embodiment, the motion driving apparatus 2 includes a three-axis positioning stage (including an X-axis positioning stage, a Y-axis positioning stage and a Z-axis positioning stage), wherein the wafer 6 carried by the carrying apparatus 5 can be moved along any direction of the X-axis direction, the Y-axis direction and the Z-axis direction by the motion driving apparatus 2. Hence, the motion driving apparatus 2 enables a relative displacement between the image capturing apparatus 3 and the wafer 6 carried by the carrying apparatus 5 along any direction of the X-axis direction, the Y-axis direction and the Z-axis direction; while the motion driving apparatus 2 also enables a relative displacement between the laser apparatus 4 and the wafer 6 carried by the carrying apparatus 5 along any direction of the X-axis direction, the Y-axis direction and the Z-axis direction. In current embodiment, the motion driving apparatus 2 has a hollow center portion 20, wherein the hollow center portion 20 of the motion driving apparatus 2 is corresponding to the hollow center portion 51 of the carrying apparatus 5 and below the hollow center portion 51 of the carrying apparatus 5.

In current embodiment, the image capturing apparatus 3 includes an image capture device 30 and a light source 32, wherein the image capture device 30 has a lens 31. The light source 32 is a coaxial light source. The image capture device 30 of the image capturing apparatus 3 is used for capturing image(s). The light source 32 is mounted to a protruding connection portion 33 of the lens 31 for emitting light. One end of the lens 31 is toward the top surface 60 of the wafer 6, wherein the image capturing apparatus 3 is disposed under the hollow center portion 20 of the motion driving apparatus 2 (or a portion of the image capturing apparatus 3, such as a portion of the lens 31, is disposed within the hollow center portion 20 of the motion driving apparatus 2), so that the light emitted by the light source 32 can propagate through the lens 31 and then propagate through the hollow center portion 20 of the motion driving apparatus 2 and the hollow center portion 51 of the carrying apparatus 5 to illuminate at least one portion of the top surface 60 of the wafer 6 (for example, at least one die 61), and so that the image capture device 30 of the image capturing apparatus 3 can capture image(s) of at least one die 61 (from the top surface 60 of the wafer 6). In some other embodiments, the light emitted by the light source 32 can illuminate the whole top surface 60 of the wafer 6 so that the image capture device 30 of the image capturing apparatus 3 can capture image(s) of each of the plurality of dies 61 (from the top surface 60 of the wafer 6).

In current embodiment, the controlling integration apparatus 8 is connected to the motion driving apparatus 2, the carrying apparatus 5, the image capture device 30 of the image capturing apparatus 3, the light source 32 of the image capturing apparatus 3 and the laser apparatus 4, wherein the controlling integration apparatus 8 is connected to the carrying apparatus 5 through the motion driving apparatus 2. The controlling integration apparatus 8 can control the carrying apparatus 5 to clamp or release the peripheral edge of the wafer 6 by the clamping device 50 of the carrying apparatus 5. The controlling integration apparatus 8 can control the motion driving apparatus 2 for driving motion, such as a relative displacement between the image capturing apparatus 3 and the wafer 6 carried by the carrying apparatus 5 and/or a relative displacement between the laser apparatus 4 and the wafer 6 carried by the carrying apparatus 5. The controlling integration apparatus 8 can control the light source 32 of the image capturing apparatus 3 for emitting light to illuminate at least one die 61 or each of the plurality of dies 61. The controlling integration apparatus 8 can control the image capture device 30 of the image capturing apparatus 3 for capturing image(s) of at least one die 61 or image(s) of each of the plurality of dies 61. The controlling integration apparatus 8 further includes an image recognition device 80, wherein the image recognition device 80 of the controlling integration apparatus 8 can receive the image(s) captured by the image capture device 30 of the image capturing apparatus 3 and then perform image recognition on the image(s) captured by the image capture device 30 of the image capturing apparatus 3. And the controlling integration apparatus 8 can also control the laser apparatus 4 to perform localized laser thinning processing on the bottom surface 63 of the wafer 6.

The present invention further provides a method for localized wafer thinning, which comprises following steps of: Step A: providing a wafer 6 to be carried by a carrying apparatus 5, wherein the wafer 6 includes a plurality of dies 61, each of the plurality of dies 61 includes at least one device 7 formed on a top surface 60 of the wafer 6; Step B: determining at least one interested feature (described in further detail below) of each of the plurality of dies 61 respectively, wherein the at least one interested feature of each of the plurality of dies 61 is related to the at least one device 7 of each of the plurality of dies 61 formed on the top surface 60 of the wafer 6 respectively; Step C: determining at least one to-be-thinned starting region (described in further detail below) and at least one interested region (described in further detail below) of each of the plurality of dies 61 according to the at least one interested feature of each of the plurality of dies 61 respectively, wherein the at least one interested feature of each of the plurality of dies 61 is within the at least one to-be-thinned starting region of each of the plurality of dies 61 respectively or identical to the at least one interested region of each of the plurality of dies 61 respectively, the at least one interested region of each of the plurality of dies 61 is (determined to be) within (but not identical to) the at least one to-be-thinned starting region of each of the plurality of dies 61 respectively or identical to the at least one to-be-thinned starting region of each of the plurality of dies 61 respectively; Step D: capturing at least one image of each of the plurality of dies 61 (in current embodiment, the at least one image of each of the plurality of dies 61 is captured from the top surface 60 of the wafer 6) by an image capturing apparatus 3; Step E: performing image recognition on the at least one image to recognize the at least one interested feature of each of the plurality of dies 61 by an image recognition device 80; and Step F: performing localized laser thinning processing on a bottom surface 63 of the wafer 6 within the at least one to-be-thinned starting region of each of the plurality of dies 61 by an laser apparatus 4 to locally thin the wafer 6 within the at least one to-be-thinned starting region of each of the plurality of dies 61, such that the wafer 6 has a desired thickness within at least one of the at least one interested region of each of the plurality of dies 61.

In the present invention, the desired thickness of the wafer 6 is not a measured thickness of the wafer 6. When an user performs localized laser thinning processing on the bottom surface 63 of the wafer 6 within a to-be-thinned starting region of a die 61, the user desires that the wafer 6 has a certain thickness within the to-be-thinned starting region of the die 61 after the wafer 6 is locally thinned, wherein the certain thickness is the desired thickness. The user relies on experience to achieve that the wafer 6 has the desired thickness within the to-be-thinned starting region of the die 61 after the wafer 6 is locally thinned. For example, the user may choose one suitable laser apparatus 4, under a certain fluence of the laser, lasting for a certain time period (or a certain amount of laser pulses) to perform localized laser thinning processing on the bottom surface 63 of the wafer 6 within the to-be-thinned starting region of the die 61. After the wafer 6 is locally thinned, the user may measure the thickness of the wafer 6 within the to-be-thinned starting region of the die 61. To compare the difference with different parameters, the user may vary the parameters, such as different laser apparatuses 4, different wafers (made of different materials), different fluences of the laser, or different time periods (or different amounts of laser pulses). The user can rely on the experience to achieve that the wafer 6 has the desired thickness within the to-be-thinned starting region of the die 61 after the wafer 6 is locally thinned. After performing localized laser thinning processing on the bottom surface 63 of the wafer 6 within the to-be-thinned starting region of each of the plurality of dies 61, the user may measure the thickness of the wafer 6 within the at least one to-be-thinned starting region of each of the plurality of dies 61. A measured thickness of the wafer 6 within the at least one to-be-thinned starting region of each of the plurality of dies 61 is the result the user measured. A difference between the measured thickness and the desired thickness of the wafer 6 within the at least one to-be-thinned starting region of each of the plurality of dies 61 can be controlled to be very small (such as

smaller than 2μm).

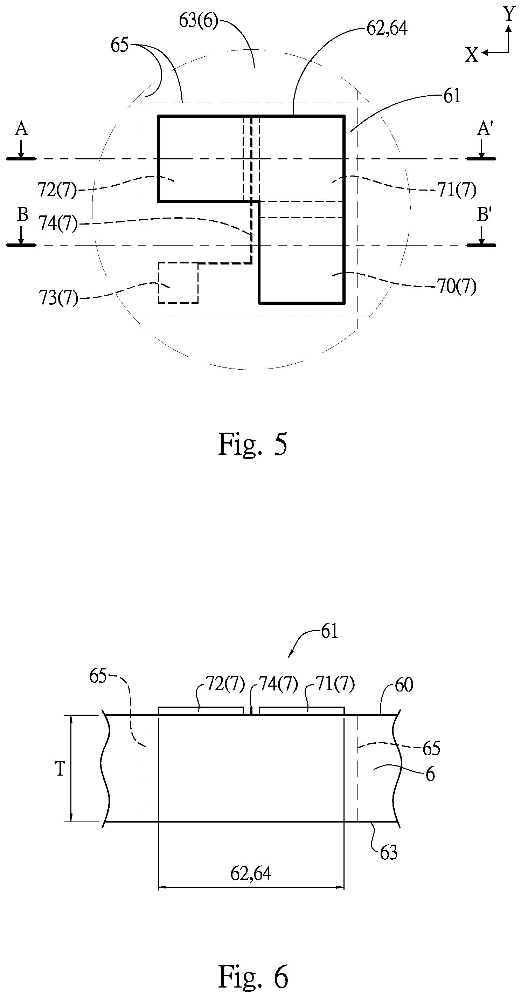

Please refer to Figure 4, which shows a schematic view of an embodiment of an interested region and a to-be-thinned starting region on the top surface of the die in Figure 3. Please also refer to Figure 5, which shows a schematic view of the interested region and the to-be-thinned starting region on a bottom surface of the die in Figure 4. In current embodiment, the wafer 6 is made of SiC. The wafer 6 has not yet been cut into separated independent dies (chips). The dotted cut lines 65 in Figures 2-5 are the boundaries of each of the plurality of dies 61. After the wafer 6 has been locally thinned by localized laser thinning processing of the present invention and after all the backside processes (optional) on a backside of the wafer 6 are processed (such as a backside metal process for forming the drain electrode of the device 7), then the wafer 6 will be cut into separated independent dies (chips) along these dotted cut lines 65. Cutting the wafer 6 into separated independent dies (chips) may be achieved by blade dicing, laser stealth dicing, plasma dicing, scribe & break, or other methods. Part of the area adjacent to the dotted cut lines 65 will be lost during cutting the wafer 6 into separated independent dies (chips). In current embodiment, in each of the plurality of dies 61, the three source electrodes 70, 71, 72 of the device 7 each occupies a front side region (as shown in Figure 3) on the top surface 60 of the wafer 6; while three backside regions (as shown in Figure 5) on the bottom surface 63 of the wafer 6 are corresponding to the three front side regions of the three source electrodes 70, 71, 72 on the top surface 60 of the wafer 6 respectively. In each of the plurality of dies 61, the three backside regions of the die 61 on the bottom surface 63 of the wafer 6 are where the three corresponding front side regions of the three source electrodes 70, 71, 72 of the device 7 on the top surface 60 of the wafer 6 respectively mapping to the bottom surface 63 of the wafer 6 along a direction from the top surface 60 of the wafer 6 to the bottom surface 63 of the wafer 6 and perpendicular to the top surface 60 of the wafer 6 (an opposition direction of the Z-axis direction). Each of the three backside regions on the bottom surface 63 of the wafer 6 and each of the three corresponding front side regions of the three source electrodes 70, 71, 72 of the device 7 on the top surface 60 of the wafer 6 have an identical shape and an identical area, respectively. The wafer 6 has an uniform thickness T; hence, if the drain electrode (has not been formed yet; not shown in Figure) of the device 7 is directly formed on the bottom surface 63 of the wafer 6 (with the wafer 6 having the uniform thickness T), then an on-resistance of the device 7 will be related to a shortest distance between the drain electrode (not shown in Figure) of the device 7 and each of the three source electrodes 70, 71, 72 of the device 7. That is, the on-resistance of the device 7 is related to the uniform thickness T of the wafer 6 within the three front side regions of the three source electrodes 70, 71, 72 of the device 7.

Since the on-resistance of the device 7 is related to the thickness of the wafer 6 within the three front side regions of the three source electrodes 70, 71, 72 of the device 7 (that is, related to the shortest distance between the drain electrode (has not been formed yet) of the device 7 and each of the three source electrodes 70, 71, 72 of the device 7); hence, if performing localized laser thinning processing of the present invention on the bottom surface 63 of the wafer 6 within the three backside regions (corresponding to the three front side regions of the three source electrodes 70, 71, 72 of the device 7) of a die 61, then the thickness of the wafer 6 within the three front side regions of the three source electrodes 70, 71, 72 of the device 7 of the die 61 will be locally reduced and three backside trenches (not shown in Figure) of the die 61 will be formed on the backside of the wafer 6. That is, a shortest distance between each of the three source electrodes 70, 71, 72 of the device 7 of the die 61 on the top surface 60 of the wafer 6 and a bottom surface of each of the three backside trenches (not shown in Figure) of the die 61 is reduced respectively. Then, after a drain electrode (not shown in Figure) of the device 7 of the die 61 is formed on the bottom surface of each of the three backside trenches (not shown in Figure) of the die 61 respectively, the shortest distance between the drain electrode (not shown in Figure) of the device 7 of the die 61 and each of the three source electrodes 70, 71, 72 of the device 7 of the die 61 will become shorter, such that the on-resistance of the device 7 of the die 61 is reduced.

Hence, in current embodiment, in each of the plurality of dies 61, the three source electrodes 70, 71, 72 of the device 7 of the die 61 formed on the top surface 60 of the wafer 6 can be determined as an interested feature of the die 61. In each of the plurality of dies 61, if the thickness of the wafer 6 within the three front side regions of the three source electrodes 70, 71, 72 of the device 7 (the region that the interested feature occupied) of the die 61 can be locally thinned by performing localized laser thinning processing of the present invention on the bottom surface 63 of the wafer 6 within the three corresponding backside regions of the die 61 by the laser apparatus 4, then the on-resistance of the device 7 of the die 61 can be effectively reduced; in the meantime, the heat dissipation of the device 7 of the die 61 can be effectively enhanced. In some embodiments, the criteria for determining the interested feature of the die 61 may be dependent on the actual design of the device 7 of the die 61 and requirements to the performance and the characteristics of the device 7 of the die 61.

However, in current embodiment, the front side region of the first source electrode 70 is very close to the front side region of the second source electrode 71 and also the front side region of the second source electrode 71 is very close to the front side region of the third source electrode 72 (with a portion of the very thin gate finger 74 between the front side region of the second source electrode 71 and the front side region of the third source electrode 72, as shown in Figure 3); hence, if performing localized laser thinning processing of the present invention on the bottom surface 63 of the wafer 6 within the three corresponding backside regions of the die 61 by the laser apparatus 4, then two very thin sidewalls (not shown in Figure) will be formed on the backside of the wafer 6. One of the two very thin sidewalls (not shown in Figure) on the backside of the wafer 6 is corresponding to a front side region between the front side region of the first source electrode 70 and the front side region of the second source electrode 71; while the other one of the two very thin sidewalls (not shown in Figure) on the backside of the wafer 6 is corresponding to a front side region between the front side region of the second source electrode 71 and the front side region of the third source electrode 72. These two very thin sidewalls (not shown in Figure) are redundant. Since these two sidewalls (not shown in Figure) are too thin, these two very thin sidewalls (not shown in Figure) may be easily damaged (such as cracked) during handling the wafer 6; and then the cracked debris may have the chance to pollute the wafer 6, other products or equipment in clean room. Removing these two very thin sidewalls (not shown in Figure) will not adversely affect the performance or the characteristics of the device 7. Furthermore, it will be simplified to remove these two very thin sidewalls during performing the localized laser thinning processing of the present invention.

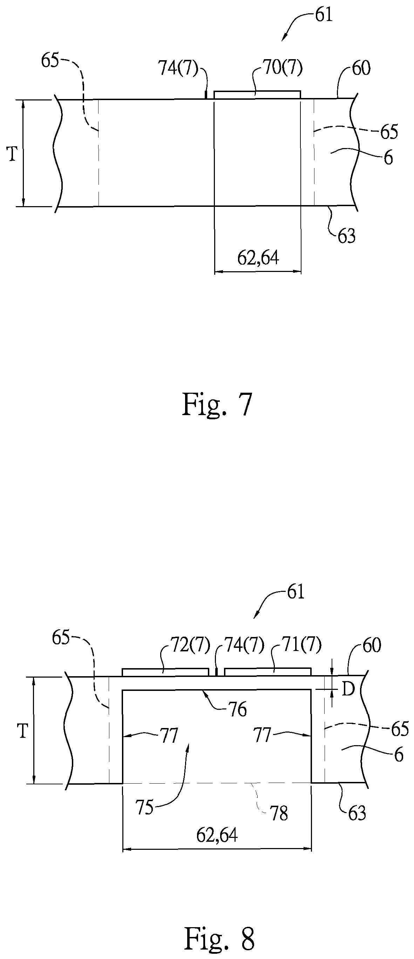

Please refer to Figure 6, which shows a cross-sectional schematic view taken along the A-A' section line in Figure 5 before the wafer has been locally thinned by localized laser thinning processing of the present invention. Please also refer to Figure 7, which shows a cross-sectional schematic view taken along the B-B' section line in Figure 5 before the wafer has been locally thinned by localized laser thinning processing of the present invention. In order to prevent these two very thin sidewalls (not shown in Figure) from existing after performing localized laser thinning processing of the present invention, the localized laser thinning processing of the present invention must be performed on the bottom surface 63 of the wafer 6 not only within the three backside regions (corresponding to the three front side regions of the three source electrodes 70, 71, 72 of the device 7) of each of the plurality of dies 61, but also within a backside region of each of the plurality of dies 61 corresponding to the front side region between the front side region of the first source electrode 70 and the front side region of the second source electrode 71 of the device 7 of each of the plurality of dies 61 and also within a backside region of each of the plurality of dies 61 corresponding to the front side region between the front side region of the second source electrode 71 and the front side region of the third source electrode 72 of the device 7 of each of the plurality of dies 61. Hence, in the present invention, a to-be-thinned starting region of each of the plurality of dies 61 may be defined as a certain region of each of the plurality of dies 61, wherein when performing localized laser thinning processing of the present invention, the localized laser thinning processing is performed on the bottom surface 63 of the wafer 6 within the certain region (the to-be-thinned starting region) of each of the plurality of dies 61 by the laser apparatus 4. **In** current embodiment, a to-be-thinned starting region 64 of each of the plurality of dies 61 is defined and shown in Figures 4-7. In each of the plurality of dies 61, the to-be-thinned starting region 64 includes: (a) the three backside regions corresponding to the three front side regions of the three source electrodes 70, 71, 72 of the device 7, (b) the backside region corresponding to the front side region between the front side region of the first source electrode 70 and the front side region of the second source electrode 71 of the device 7 and (c) the backside region corresponding to the front side region between the front side region of the second source electrode 71 and the front side region of the third source electrode 72 of the device 7. After performing localized laser thinning processing of the present invention on the bottom surface 63 of the wafer 6 within the to-be-thinned starting region 64 of each of the plurality of dies 61, there will be no such two very thin sidewalls (not shown in Figure) mentioned the above.

In fact, in current embodiment, if combining (1) the three front side regions of the three source electrodes 70, 71, 72 of the device 7 of each of the plurality of dies 61, (2) the front side region between the front side region of the first source electrode 70 and the front side region of the second source electrode 71 of the device 7 of each of the plurality of dies 61 and (3) the front side region between the front side region of the second source electrode 71 and the front side region of the third source electrode 72 of the device 7 of each of the plurality of dies 61 into an unseparated front side region of each of the plurality of dies 61 respectively, then the unseparated front side region of each of the plurality of dies 61 is actually a minimum unseparated front side region of each of the plurality of dies 61 that covers the interested feature of each of the plurality of dies 61 (a minimum unseparated front side region that covers the three front side regions of the three source electrodes 70, 71, 72 of the device 7 of each of the plurality of dies 61) respectively. That is, in current embodiment, the to-be-thinned starting region 64 of each of the plurality of dies 61 is determined to be corresponding to the unseparated front side region of each of the plurality of dies 61 respectively.

After performing localized laser thinning processing of the present invention on the bottom surface 63 of the wafer 6 within the to-be-thinned starting region 64 of each of the plurality of dies 61, at least one backside trench (not shown in Figure) of each of the plurality of dies 61 will be formed on the backside of the wafer 6. Since the localized laser thinning processing of the present invention is performed by the laser apparatus 4, a shape of a sidewall of the at least one backside trench (not shown in Figure) of each of the plurality of dies 61 may be upright (perpendicular to the bottom surface 63 of the wafer 6), stepped, tapered (not perpendicular to the bottom surface 63 of the wafer 6) or a combination of stepped and tapered. When the localized laser thinning processing is finished (or stopped), a bottom surface of the at least one backside trench (not shown in Figure) of each of the plurality of dies 61 is formed respectively and a region occupied by the bottom surface of the at least one backside trench (not shown in Figure) of each of the plurality of dies 61 is defined respectively. The region occupied by the bottom surface of the at least one backside trench (not shown in Figure) of each of the plurality of dies 61 must be within (but not identical to) the to-be-thinned starting region 64 of each of the plurality of dies 61 respectively or identical to the to-be-thinned starting region 64 of each of the plurality of dies 61 respectively. In the present invention, an interested region (not shown in Figure) of each of the plurality of dies 61 defines the region occupied by the bottom surface of the at least one backside trench (not shown in Figure) of each of the plurality of dies 61 respectively; that is, the interested region (not shown in Figure) of each of the plurality of dies 61 defines the region where the localized laser thinning processing finished (or stopped). In current embodiment, an interested region 62 of each of the plurality of dies 61 is defined and shown in Figures 4-7.

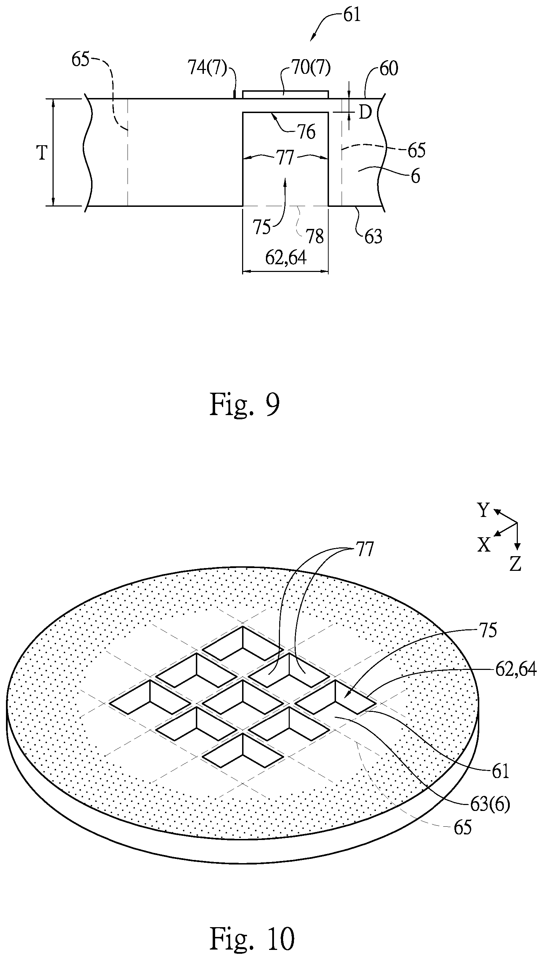

Please also refer to Figures 8 and 9, which respectively show cross-sectional schematic views taken along the A-A' section line and the B-B' section line in Figure 5 after the wafer has been locally thinned within the to-be-thinned starting region of the die by localized laser thinning processing of the present invention. Please also refer to Figure 10, which shows a perspective schematic view of a bottom surface of the wafer of Figure 5 after the wafer has been locally thinned within the to-be-thinned starting region of the die by localized laser thinning processing of the present invention. In current embodiment, after performing localized laser thinning processing of the present invention on the bottom surface 63 of the wafer 6 within the to-be-thinned starting region 64 of each of the plurality of dies 61, a backside trench 75 of each of the plurality of dies 61 is formed on the backside of the wafer 6. The backside trench 75 of each of the plurality of dies 61 has a bottom surface 76, a sidewall 77 and an opening 78 on the bottom surface 63 of the wafer 6 respectively. In current embodiment, the interested region 62 of each of the plurality of dies 61 (a region occupied by the bottom surface 76 of the backside trench 75 of each of the plurality of dies 61) is (determined to be) identical to the to-be-thinned starting region 64 of each of the plurality of dies 61 respectively; hence, a shape of the sidewall 77 of the backside trench 75 of each of the plurality of dies 61 is upright. After performing localized laser thinning processing of the present invention on the bottom surface 63 of the wafer 6 within the to-be-thinned starting region 64 of each of the plurality of dies 61, the localized laser thinning processing is finished (or stopped) within the interested region 62 of each of the plurality of dies 61, such that the wafer 6 has a desired thickness D within the interested region 62 of each of the plurality of dies 61. Later on, a backside metal (not shown in Figure) may be formed on the bottom surface 63 of the wafer 6, the bottom surface 76 of the backside trench 75 and the sidewall surface 77 of the backside trench 75 of each of the plurality of dies 61, such that a drain electrode (not shown in Figure) of the device 7 of each of the plurality of dies 61 is formed at least on the bottom surface 76 of the backside trench 75. The shortest distance between the drain electrode (not shown in Figure) of the device 7 and each of the three source electrodes 70, 71, 72 of the device 7 of each of the plurality of dies 61 becomes shorter; hence, the on-resistance of the device 7 of each of the plurality of dies 61 can be effectively reduced and, in the meantime, the heat dissipation of the device 7 of each of the plurality of dies 61 can be effectively enhanced.

In Figure 10, the wafer 6 has the desired thickness D within the interested region 62; while the wafer 6 has the uniform thickness T beyond the to-be-thinned starting region 64 of each of the plurality of dies 61 (as shown in Figures 8 and 9). Hence, the wafer 6 not only has the thickness T around a peripheral edge (adjacent to the dotted cut lines 65) of each of the plurality of dies 61, but also has the thickness T within a front side region of the gate electrode 73 of the device 7, a front side region between the front side region of the gate electrode 73 and the front side region of the first source electrode 70 of the device 7 and a front side region between the front side region of the gate electrode 73 and the front side region of the third source electrode 72 of the device 7. Therefore, the mechanical strength of the whole wafer 6 is enhanced.

Before performing localized laser thinning processing of the present invention on the bottom surface 63 of the wafer 6 within the at least one to-be-thinned starting region of each of the plurality of dies 61 by the laser apparatus 4, the interested region and the to-be-thinned starting region of each of the plurality of dies 61 must be determined. In current embodiment, the interested region 62 and the to-be-thinned starting region 64 of each of the plurality of dies 61 may be determined according to the interested feature of each of the plurality of dies 61 respectively (for example, the interested feature of each of the plurality of dies 61 is related to the performance and the characteristics of the device 7 of each of the plurality of dies 61 respectively), a shape of the sidewall 77 of the backside trench 75 of each of the plurality of dies 61 respectively (for example, the shape of the sidewall 77 of the backside trench 75 is determined to be upright, stepped, tapered or a combination of stepped and tapered), and some other criteria (for example, the above mentioned for removing the two very thin sidewalls).

In the embodiment of Figures 1-10, the method for localized wafer thinning of the present invention comprises following steps: Step A: providing a wafer 6 to be carried by a carrying apparatus 5, wherein a top surface 60 of the wafer 6 is facing down (that is, a bottom surface 63 of the wafer 6 facing up), the wafer 6 includes a plurality of dies 61, a device 7 (including three source electrodes 70, 71, 72, a gate electrode 73 and a gate finger 74) of each of the plurality of dies 61 is formed on the top surface 60 of the wafer 6 respectively, wherein the wafer 6 has an uniform thickness T; Step B: determining the three source electrodes 70, 71, 72 of the device 7 of each of the plurality of dies 61 on the top surface 60 of the wafer 6 to be an interested feature of each of the plurality of dies 61 respectively; Step C: determining a to-be-thinned starting region 64 and an interested region 62 of each of the plurality of dies 61 according to the interested feature of each of the plurality of dies 61 respectively, wherein the to-be-thinned starting region 64 of each of the plurality of dies 61 is determined to be corresponding to an unseparated front side region of each of the plurality of dies 61 respectively, wherein the unseparated front side region of each of the plurality of dies 61 (a combination of (1) the three front side regions of the three source electrodes 70, 71, 72 of the device 7 of each of the plurality of dies 61, (2) the front side region between the front side region of the first source electrode 70 and the front side region of the second source electrode 71 of the device 7 of each of the plurality of dies 61 and (3) the front side region between the front side region of the second source electrode 71 and the front side region of the third source electrode 72 of the device 7 of each of the plurality of dies 61 respectively) is a minimum unseparated front side region of each of the plurality of dies 61 that covers the interested feature of each of the plurality of dies 61 (a minimum unseparated front side region that covers the three front side regions of the three source electrodes 70, 71, 72 of the device 7 of each of the plurality of dies 61) respectively, wherein the interested region 62 of each of the plurality of dies 61 is (determined to be) identical to the to-be-thinned starting region 64 of each of the plurality of dies 61 respectively, wherein the interested feature of each of the plurality of dies 61 is within the to-be-thinned starting region 64 of each of the plurality of dies 61 respectively; Step D: capturing at least one image of each of the plurality of dies 61 (in current embodiment, the at least one image of each of the plurality of dies 61 is captured from the top surface 60 of the wafer 6) by an image capture device 30 of an image capturing apparatus 3; Step E: performing image recognition on the at least one image of each of the plurality of dies 61 taken by the image capture device 30 of the image capturing apparatus 3 to recognize the interested feature (the three source electrodes 70, 71, 72 of the device 7) of each of the plurality of dies 61 by an image recognition device 80 of a controlling integration apparatus 8; and Step F: performing localized laser thinning processing on the bottom surface 63 of the wafer 6 within the to-be-thinned starting region 64 of each of the plurality of dies 61 by an laser apparatus 4 to locally thin the wafer 6 within the to-be-thinned starting region 64 of each of the plurality of dies 61, such that the wafer 6 has a desired thickness D within the interested region 62 of each of the plurality of dies 61.

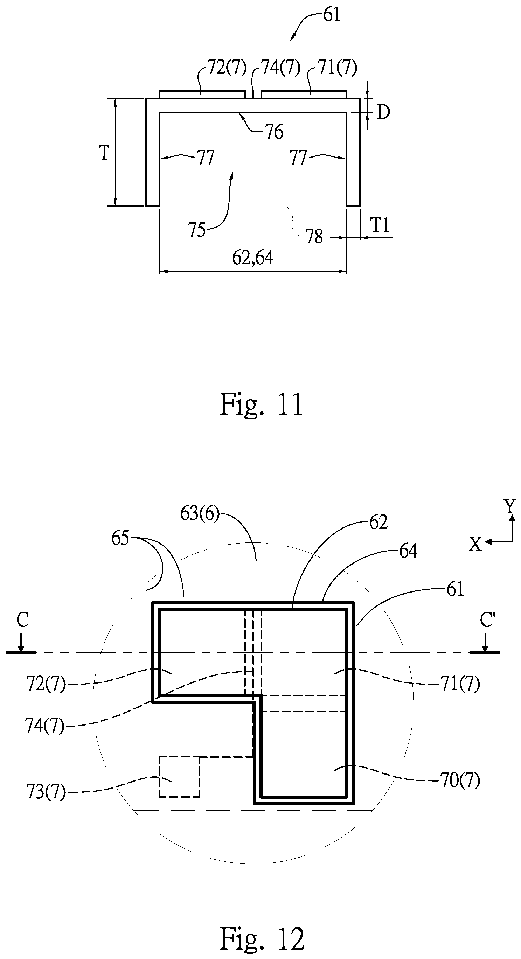

Please refer to Figure 11, which shows a cross-sectional schematic view of the die cut from the wafer in Figure 8. After the wafer 6 has been locally thinned by localized laser thinning processing of the present invention, then a drain electrode (not shown in Figure) of the device 7 of each of the plurality of dies 61 may be formed at least on the bottom surface 76 of the backside trench 75 of each of the plurality of dies 61. Then the wafer 6 can be cut into separated independent dies (chips) along these dotted cut lines 65. One of the separated independent die (chip) 61 is shown in Figure 11. The sidewall 77 of the backside trench 75 of the separated independent die (chip) 61 has a sidewall thickness T1. Therefore, not only the mechanical strength of the whole wafer 6 is enhanced, but also the mechanical strength of each of the separated independent dies (chips) 61 is enhanced after the plurality of dies 61 is cut into the separated independent dies (chips) 61. In current embodiment, the device 7 is a power device. Before die attach process, it is better to fill thermally conductive dielectric materials into the backside trench 75 of the separated independent dies (chips) 61 for effectively enhancing heat dissipation of the device 7 (the power device).

In some embodiments, if the front side region of the first source electrode 70 of the device 7 is not very close to the front side region of the second source electrode 71 of the device 7 and the front side region of the second source electrode 71 of the device 7 is not very close to the front side region of the third source electrode 72 of the device 7, then the to-be-thinned starting region 64 of each of the plurality of dies 61 can be determined to be the three backside regions of the device 7 of each of the plurality of dies 61 respectively (corresponding to the three front side regions of the three source electrodes 70, 71, 72 of the device 7 of each of the plurality of dies 61).

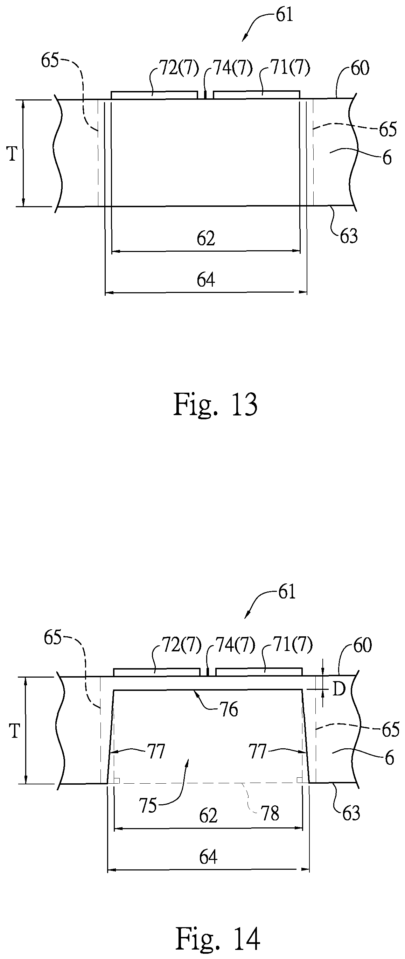

Please refer to Figure 12, which shows a schematic view of another embodiment of an interested region and a to-be-thinned starting region on the bottom surface of the die in Figure 3. Please also refer to Figure 13, which shows a cross-sectional schematic view taken along the C-C' section line in Figure 12 before the wafer has been locally thinned by localized laser thinning processing of the present invention. The main structure of the embodiment of Figures 12 and 13 is basically the same as the structure of the embodiment of Figures 1-7, except that the interested region 62 of each of the plurality of dies 61 is (determined to be) within (but not identical to) the to-be-thinned starting region 64 of each of the plurality of dies 61 respectively. In current embodiment, the interested feature and the interested region 62 of each of the plurality of dies 61 are the same as the interested feature and the interested region 62 of each of the plurality of dies 61 of the embodiment of Figures 1-7; while, in current embodiment, the to-be-thinned starting region 64 of each of the plurality of dies 61 is wider than the to-be-thinned starting region 64 of each of the plurality of dies 61 of the embodiment of Figures 1-7. Please also refer to Figure 14, which shows a cross-sectional schematic view taken along the C-C' section line in Figure 12 after the wafer has been locally thinned within the to-be-thinned starting region of the die by localized laser thinning processing of the present invention. After performing localized laser thinning processing of the present invention on the bottom surface 63 of the wafer 6 within the to-be-thinned starting region 64 of each of the plurality of dies 61, a backside trench 75 of each of the plurality of dies 61 is formed on the backside of the wafer 6. The backside trench 75 of each of the plurality of dies 61 has a bottom surface 76, a sidewall 77 and an opening 78 on the bottom surface 63 of the wafer 6. In current embodiment, the interested region 62 of each of the plurality of dies 61 is (determined to be) within (but not identical to) the to-be-thinned starting region 64 of each of the plurality of dies 61 respectively; and a shape of the sidewall 77 of the backside trench 75 of each of the plurality of dies 61 is (determined to be) tapered (the tapered shape of the sidewall 77 of the backside trench 75 can be approached by a combination of many stepped shapes). A region occupied by the opening 78 of the backside trench 75 of each of the plurality of dies 61 on the bottom surface 63 of the wafer 6 is identical to the to-be-thinned starting region 64 of each of the plurality of dies 61 respectively. The interested region 62 of each of the plurality of dies 61 is identical to a region occupied by the bottom surface 76 of the backside trench 75 of each of the plurality of dies 61 respectively. The region occupied by the opening 78 of the backside trench 75 of each of the plurality of dies 61 is wider than the region occupied by the bottom surface 76 of the backside trench 75 of each of the plurality of dies 61 respectively;

hence, when forming a backside metal (not shown in Figure) on the bottom surface 63 of the wafer 6, the bottom surface 76 of the backside trench 75 and the sidewall surface 77 of the backside trench 75 of each of the plurality of dies 61, it will result a more uniform thickness of the backside metal (not shown in Figure). In current embodiment, the wafer 6 has a desired thickness D within the interested region 62 of each of the plurality of dies 61.

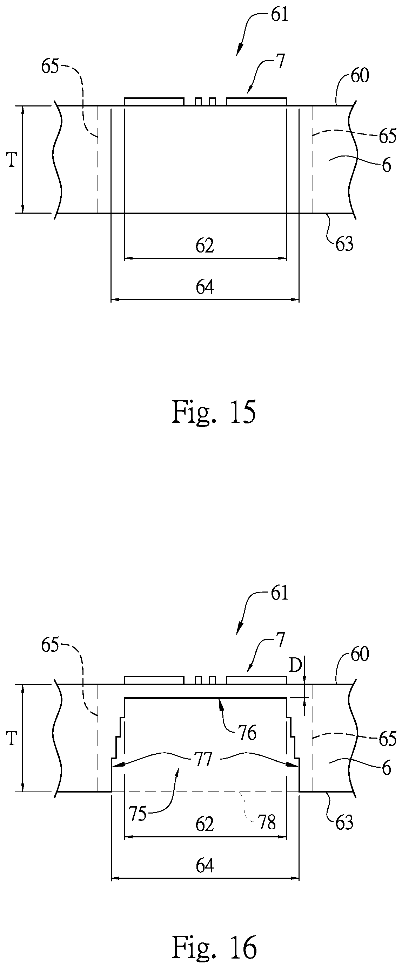

Please refer to Figure 15, which shows a cross-sectional schematic view of another embodiment of an interested region and a to-be-thinned starting region of a die before the wafer has been locally thinned by localized laser thinning processing of the present invention. In current embodiment, a wafer 6 includes a plurality of dies 61, wherein each of the plurality of dies 61 includes only one device 7 (the device 7 is not a power device as shown in Figure 3), wherein the interested feature of each of the plurality of dies 61 is determined to be the device 7 of each of the plurality of dies 61 on the top surface 60 of the wafer 6 respectively, wherein the to-be-thinned starting region 64 of each of the plurality of dies 61 is determined such that the interested feature of each of the plurality of dies 61 is within (but not identical to) the to-be-thinned starting region 64 of each of the plurality of dies 61 respectively (the to-be-thinned starting region 64 of each of the plurality of dies 61 covers an active region of the device 7 of each of the plurality of dies 61 on the top surface 60 of the wafer 6 respectively), wherein the interested region 62 of each of the plurality of dies 61 is (determined to be) within (but not identical to) the to-be-thinned starting region 64 of each of the plurality of dies 61 respectively, and the interested region 62 of each of the plurality of dies 61 is (determined to be) identical to the interested feature of each of the plurality of dies 61 respectively. Please also refer to Figure 16, which shows a cross-sectional schematic view of the die in Figure 15 after the wafer has been locally thinned within the to-be-thinned starting region of the die by localized laser thinning processing of the present invention. After performing localized laser thinning processing of the present invention on the bottom surface 63 of the wafer 6 within the to-be-thinned starting region 64 of each of the plurality of dies 61, a backside trench 75 of each of the plurality of dies 61 is formed on the backside of the wafer 6. The backside trench 75 of each of the plurality of dies 61 has a bottom surface 76, a sidewall 77 and an opening 78 on the bottom surface 63 of the wafer 6. In current embodiment, the interested region 62 of each of the plurality of dies 61 is (determined to be) within (but not identical to) the to-be-thinned starting region 64 of each of the plurality of dies 61 respectively; and a shape of the sidewall 77 of the backside trench 75 of each of the plurality of dies 61 is (determined to be) stepped. A region occupied by the opening 78 of the backside trench 75 of each of the plurality of dies 61 on the bottom surface 63 of the wafer 6 is identical to the to-be-thinned starting region 64 of each of the plurality of dies 61 respectively. The interested region 62 of each of the plurality of dies 61 is identical to a region occupied by the bottom surface 76 of the backside trench 75 of each of the plurality of dies 61 respectively. The region occupied by the opening 78 of the backside trench 75 of each of the plurality of dies 61 is wider than the region occupied by the bottom surface 76 of the backside trench 75 of each of the plurality of dies 61 respectively. The sidewall 77 (stepped sidewall) of the backside trench 75 of each of the plurality of dies 61 may have different design in shape (for example, two steps, three steps or more steps, with different step height or uniform step height). The design of a shape of the sidewall 77 (stepped sidewall) of the backside trench 75 of each of the plurality of dies 61 may be according to the performance or the characteristics of the device 7 or some other criteria. In current embodiment, the wafer 6 has a desired thickness D within the interested region 62 of each of the plurality of dies 61.

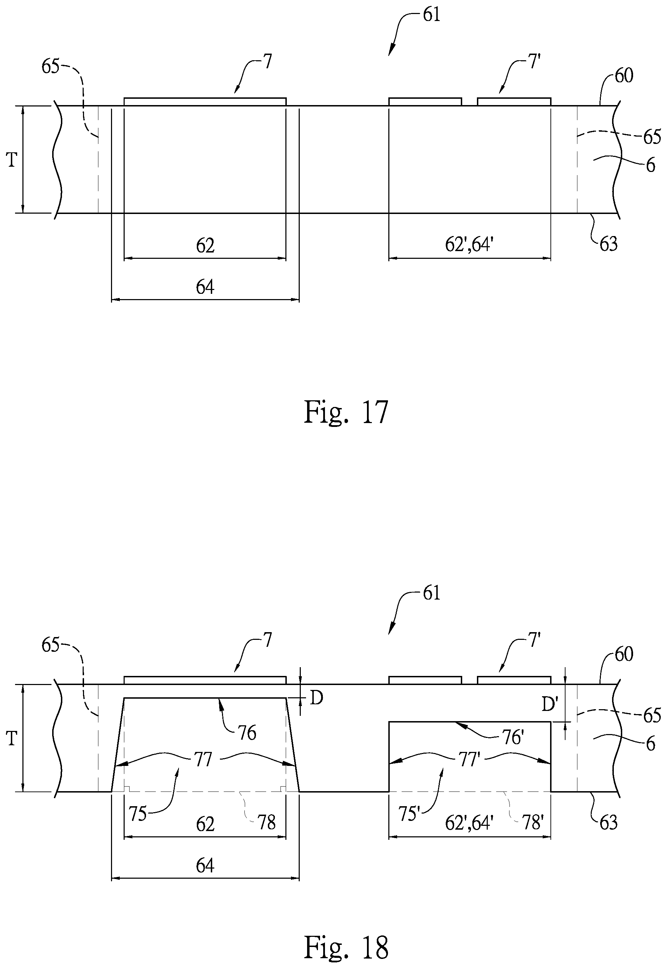

Please refer to Figure 17, which shows a cross-sectional schematic view of another embodiment of two interested regions and two to-be-thinned starting regions of a die before the wafer has been locally thinned by localized laser thinning processing of the present invention. In current embodiment, a wafer 6 includes a plurality of dies 61, wherein each of the plurality of dies 61 includes a device 7 and a device 7', wherein the device 7 and the device 7' are not power devices as shown in Figure 3, wherein two interested features of each of the plurality of dies 61 are determined, wherein the first interested feature of each of the plurality of dies 61 is determined to be the device 7 of each of the plurality of dies 61 respectively; while the second interested feature of each of the plurality of dies 61 is determined to be the device 7' of each of the plurality of dies 61 respectively; wherein a to-be-thinned starting region 64 of each of the plurality of dies 61 is determined such that the first interested feature of each of the plurality of dies 61 is within (but not identical to) the to-be-thinned starting region 64 of each of the plurality of dies 61 respectively (the to-be-thinned starting region 64 of each of the plurality of dies 61 covers an active region of the device 7 of each of the plurality of dies 61 on the top surface 60 of the wafer 6 respectively); while a to-be-thinned starting region 64' of each of the plurality of dies 61 is determined to be identical to the second interested feature of each of the plurality of dies 61 respectively (the to-be-thinned starting region 64' of each of the plurality of dies 61 covers an active region of the device 7' of each of the plurality of dies 61 on the top surface 60 of the wafer 6 respectively); wherein a interested region 62 of each of the plurality of dies 61 is (determined to be) within (but not identical to) the to-be-thinned starting region 64 of each of the plurality of dies 61 respectively; while a interested region 62' of each of the plurality of dies 61 is (determined to be) identical to the to-be-thinned starting region 64' of each of the plurality of dies 61 respectively; wherein the interested region 62 of each of the plurality of dies 61 is (determined to be) identical to the first interested feature of each of the plurality of dies 61 respectively; while the interested region 62' of each of the plurality of dies 61 is (determined to be) identical to the second interested feature of each of the plurality of dies 61 respectively. In current embodiment, in each of the plurality of dies 61, a gap is between the to-be-thinned starting region 64 and the to-be-thinned starting region 64'; wherein a gap between the first interested feature (the device 7) and the second interested feature (the device 7') is greater than the gap between the to-be-thinned starting region 64 and the to-be-thinned starting region 64'. In current embodiment, in each of the plurality of dies 61, the gap between the to-be-thinned starting region 64 and the to-be-thinned starting region 64' is great than or equal to a gap threshold; hence, (1) two separated to-be-thinned starting regions (in current embodiment, the to-be-thinned starting region 64 and the to-be-thinned starting region 64') can be determined, wherein the two separated to-be-thinned starting regions (in current embodiment, the to-be-thinned starting region 64 and the to-be-thinned starting region 64') cover the first interested feature (the device 7) and the second interested feature (the device 7') respectively, or (2) an unseparated to-be-thinned starting region can be determined (not current embodiment, not shown in Figure), wherein the unseparated to-be-thinned starting region covers the first interested feature (the device 7) and the second interested feature (the device 7'); for example, the unseparated to-be-thinned starting region can be determined to be a combination of the to-be-thinned starting region 64 and the to-be-thinned starting region 64'. Please also refer to Figure 18, which shows a cross-sectional schematic view of the die in Figure 17 after the wafer has been locally thinned within the to-be-thinned starting region of the die by localized laser thinning processing of the present invention. After performing localized laser thinning processing of the present invention on the bottom surface 63 of the wafer 6 within the to-be-thinned starting region 64 and the to-be-thinned starting region 64' of each of the plurality of dies 61 respectively, a backside trench 75 of the device 7 and a backside trench 75' of the device 7' of each of the plurality of dies 61 are formed on the backside of the wafer 6 respectively. The backside trench 75 of the device 7 of each of the plurality of dies 61 has a bottom surface 76, a sidewall 77 and an opening 78 on the bottom surface 63 of the wafer 6. The backside trench 75' of the device 7' of each of the plurality of dies 61 has a bottom surface 76', a sidewall 77' and an opening 78' on the bottom surface 63 of the wafer 6. In current embodiment, the interested region 62 of each of the plurality of dies 61 is (determined to be) within (but not identical to) the to-be-thinned starting region 64 of each of the plurality of dies 61 respectively; and a shape of the sidewall 77 of the backside trench 75 of the device 7 of each of the plurality of dies 61 is (determined to be) tapered (the tapered shape of the sidewall 77 of the backside trench 75 can be approached by a combination of many stepped shapes). A region occupied by the opening 78 of the backside trench 75 of the device 7 of each of the plurality of dies 61 on the bottom surface 63 of the wafer 6 is identical to the to-be-thinned starting region 64 of each of the plurality of dies 61 respectively. The interested region 62 of each of the plurality of dies 61 is identical to a region occupied by the bottom surface 76 of the backside trench 75 of the device 7 of each of the plurality of dies 61 respectively. The region occupied by the opening 78 of the backside trench 75 of the device 7 of each of the plurality of dies 61 is wider than the region occupied by the bottom surface 76 of the backside trench 75 of the device 7 of each of the plurality of dies 61 respectively; hence, when forming a backside metal (not shown in Figure) on the bottom surface 63 of the wafer 6, the bottom surface 76 of the backside trench 75 and the sidewall surface 77 of the backside trench 75 of the device 7 of each of the plurality of dies 61, it will result a more uniform thickness of the backside metal (not shown in Figure). The interested region 62' of each of the plurality of dies 61 is (determined to be) identical to the to-be-thinned starting region 64' of each of the plurality of dies 61 respectively; hence, a shape of the sidewall 77' of the backside trench 75' of the device 7' of each of the plurality of dies 61 is upright. A region occupied by the opening 78' of the backside trench 75' of the device 7' of each of the plurality of dies 61 on the bottom surface 63 of the wafer 6 is identical to the to-be-thinned starting region 64' of each of the plurality of dies 61 respectively. The interested region 62' of each of the plurality of dies 61 is identical to a region occupied by the bottom surface 76' of the backside trench 75' of the device 7' of each of the plurality of dies 61 respectively. The opening 78' of the backside trench 75' of the device 7' of each of the plurality of dies 61 and the bottom surface 76' of the backside trench 75' of the device 7' of each of the plurality of dies 61 have an identical shape and an identical area respectively. In current embodiment, the wafer 6 has a desired thickness D within the interested region 62 of each of the plurality of dies 61; while the wafer 6 has a desired thickness D' within the interested region 62' of each of the plurality of dies 61, wherein the desired thickness D is not equal to the desired thickness D' (in current embodiment, the desired thickness D' is greater than the desired thickness D).

In some embodiments, there is a plurality of interested features of each of the plurality of dies 61. For example, in each of the plurality of dies 61, if a gap between any two separated interested features of the die 61 is smaller than the gap threshold, then an unseparated to-be-thinned starting region 64 of the die 61 will be determined, wherein the unseparated to-be-thinned starting region 64 of the die 61 covers the two separated interested features of the die 61; while if the gap between the two separated interested features of the die 61 is great than or equal to the gap threshold, then (1) an unseparated to-be-thinned starting region 64 of the die 61 can be determined, wherein the unseparated to-be-thinned starting region 64 of the die 61 covers the two separated interested features of the die 61 or (2) two separated to-be-thinned starting regions of the die 61 can be determined, wherein the two separated to-be-thinned starting regions of the die 61 cover the two separated interested features of the die 61 respectively, and a gap between the two separated to-be-thinned starting regions of the die 61 also must be greater than or equal to the gap threshold. Hence, the gap threshold is a minimum gap between two separated to-be-thinned starting regions of the die 61. In some embodiments, the gap threshold is greater than or equal to $120\mu m$ and smaller than or equal to $150\mu m$. In some other embodiments, the gap threshold is greater than or equal to $100\mu m$ and smaller than or equal to $120\mu m$. In some other embodiments, the gap threshold is greater than or equal to $80\mu m$ and smaller than or equal to $100\mu m$. In some other embodiments, the gap threshold is greater than or equal to $50\mu m$ and smaller than or equal to $80\mu m$. In some other embodiments, the gap threshold is greater than or equal to $20\mu m$ and smaller than or equal to $50\mu m$. In some other embodiments, the gap threshold is greater than or equal to 15μm and smaller than or equal to 20μm. In some other embodiments, the gap threshold is greater than or equal to 10μm and smaller than or equal to 15μm.

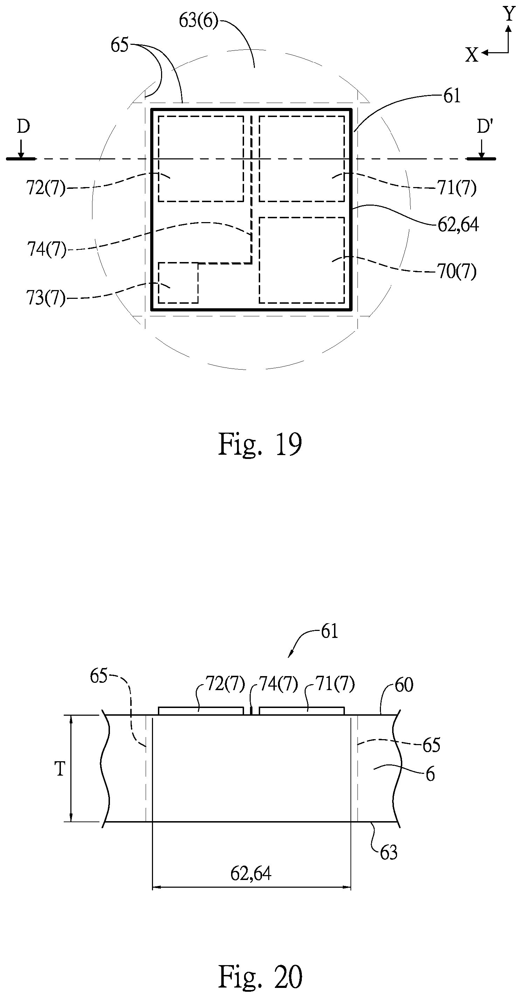

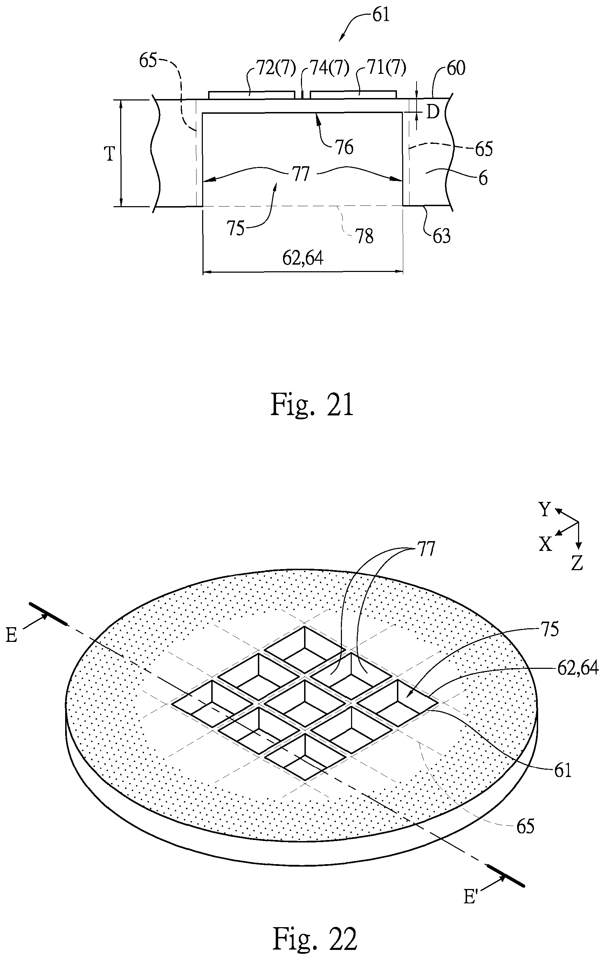

Please refer to Figure 19, which shows a schematic view of another embodiment of an interested region and a to-be-thinned starting region on the bottom surface of the die in Figure 3. Please also refer to Figure 20, which shows a cross-sectional schematic view taken along the D-D' section line in Figure 19 before the wafer has been locally thinned by localized laser thinning processing of the present invention. The main structure of the embodiment of Figures 19-20 is basically the same as the structure of the embodiment of Figures 1-7, except that the interested feature of each of the plurality of dies 61 includes (is determined to include) the three source electrodes 70, 71, 72, the gate electrode 73 and the gate finger 74 of the device 7 of each of the plurality of dies 61 formed on the top surface 60 of the wafer 6 respectively (that is, in each of the plurality of dies 61, the interested feature includes (is determined to include) the device 7 formed on the top surface 60 of the wafer 6); the to-be-thinned starting region 64 of each of the plurality of dies 61 is determined such that the interested feature of each of the plurality of dies 61 is within (but not identical to) the to-be-thinned starting region 64 of each of the plurality of dies 61 respectively (the to-be-thinned starting region 64 of each of the plurality of dies 61 covers the three source electrodes 70, 71, 72, the gate electrode 73 and the gate finger 74 of the device 7 of each of the plurality of dies 61 on the top surface 60 of the wafer 6 respectively); and the interested region 62 of each of the plurality of dies 61 is (determined to be) identical to the to-be-thinned starting region 64 of each of the plurality of dies 61 respectively. That is, in current embodiment, an active region of the device 7 of each of the plurality of dies 61 is within (but not identical to) the to-be-thinned starting region 64 of each of the plurality of dies 61 respectively and within (but not identical to) the interested region 62 of each of the plurality of dies 61 respectively. Please also refer to Figure 21, which shows a cross-sectional schematic view taken along the D-D' section line in Figure 19 after the wafer has been locally thinned within the to-be-thinned starting region of the die by localized laser thinning processing of the present invention. Please also refer to Figure 22, which shows a perspective schematic view of the bottom surface of the wafer of Figure 19 after the wafer has been locally thinned within the to-be-thinned starting region of the die by localized laser thinning processing of the present invention. After performing localized laser thinning processing of the present invention on the bottom surface 63 of the wafer 6 within the to-be-thinned starting region 64 of each of the plurality of dies 61, a backside trench 75 of each of the plurality of dies 61 is formed on the backside of the wafer 6. The backside trench 75 of each of the plurality of dies 61 has a bottom surface 76, a sidewall 77 and an opening 78 on the bottom surface 63 of the wafer 6. In current embodiment, the interested region 62 of each of the plurality of dies 61 is (determined to be) identical to the to-be-thinned starting region 64 of each of the plurality of dies 61 respectively; hence, a shape of the sidewall 77 of the backside trench 75 of each of the plurality of dies 61 is upright. A region occupied by the opening 78 of the backside trench 75 of each of the plurality of dies 61 on the bottom surface 63 of the wafer 6 is identical to the to-be-thinned starting region 64 of each of the plurality of dies 61 respectively. The interested region 62 of each of the plurality of dies 61 is identical to a region occupied by the bottom surface 76 of the backside trench 75 of each of the plurality of dies 61 respectively. The opening 78 of the backside trench 75 of each of the plurality of dies 61 and the bottom surface 76 of the backside trench 75 of each of the plurality of dies 61 have an identical shape and an identical area respectively. In current embodiment, the wafer 6 has a desired thickness D within the interested region 62 of each of the plurality of dies 61.

In the embodiment of Figure 21, after the wafer 6 has been locally thinned by localized laser thinning processing of the present invention, then a drain electrode (not shown in Figure) of the device 7 of each of the plurality of dies 61 may be formed at least on the bottom surface 76 of the backside trench 75 of each of the plurality of dies 61. Then the wafer 6 can be cut into separated independent dies (chips) along these dotted cut lines 65, wherein the main structure of each of the separated independent dies (chips) 61 of the embodiment of Figure 21 is basically the same as the structure of the embodiment of Figure 11, except that a sidewall thickness of the sidewall 77 is a little bit thinner than the sidewall thickness T1 of the sidewall 77 of the embodiment of Figure 11. The mechanical strength of each of the separated independent dies (chips) 61 may still be enhanced after the plurality of dies 61 is cut into the separated independent dies (chips) 61.

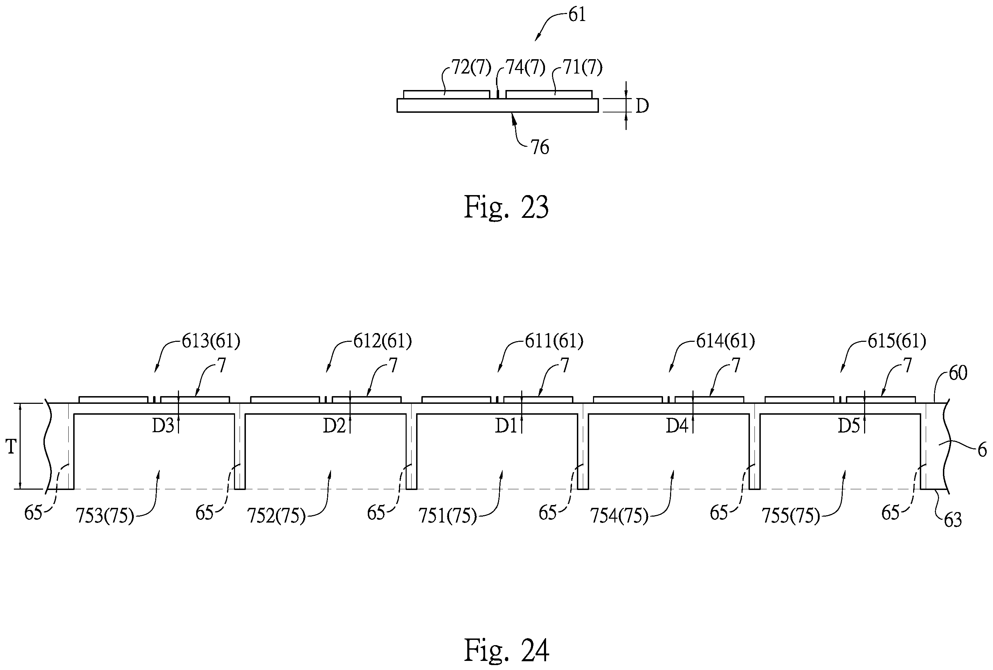

Please refer to Figure 23, which shows a cross-sectional schematic view of the die cut from the wafer in Figure 21. In the embodiment of Figure 21, after the wafer 6 has been locally thinned by localized laser thinning processing of the present invention, then a drain electrode (not shown in Figure) of the device 7 of each of the plurality of dies 61 may be formed at least on the bottom surface 76 of the backside trench 75 of each of the plurality of dies 61. Then the wafer 6 can be cut into separated independent dies (chips) along the sidewall 77 of the backside trench 75 of each of the plurality of dies 61 (not along these dotted cut lines 65). One of the separated independent dies (chip) 61 is shown in Figure 23. The structure of the separated independent die (chip) 61 in the embodiment of Figure 23 has no backside trench 75 (no sidewall 77 of the backside trench 75). Thermally conductive dielectric materials can be directly coated on the bottom surface 76 for more effectively enhancing heat dissipation of the device 7.

In some embodiments, the system for localized wafer thinning 1 of the present invention further comprises a distance measuring apparatus (not shown in Figure), wherein the distance measuring apparatus is disposed above the bottom surface 63 of the wafer 6 (for example, the distance measuring apparatus is disposed next to the laser apparatus 4). Before performing localized laser thinning processing of the present invention on the bottom surface 63 of the wafer 6 within the to-be-thinned starting region 64 of each of the plurality of dies 61 by the laser apparatus 4, the distance measuring apparatus is moved to a measuring position above the bottom surface 63 of the wafer 6 (for example, the measuring position is above one point of the bottom surface 63 of the wafer 6, wherein the one point is within a to-be-thinned starting region 64 of a die 61). And then the distance measuring apparatus measures an initial distance between the distance measuring apparatus and the one point of the bottom surface 63 of the wafer 6. And then the distance measuring apparatus is moved away. After performing localized laser thinning processing of the present invention on the bottom surface 63 of the wafer 6 within the to-be-thinned starting region 64 of each of the plurality of dies 61, the distance measuring apparatus is moved to the measuring position or other position (above the other point within a to-be-thinned starting region 64 of another die 61) and then the distance measuring apparatus measures a final distance between the distance measuring apparatus and a bottom surface 76 of a backside trench 75 of the die 61 (or a bottom surface 76 of a backside trench 75 of another die 61). Since, the wafer 6 originally has the uniform thickness T; hence, a measured thickness of the wafer 6 can be calculated as follows:

$$\text{the measured thickness} =$$

$$\text{the uniform thickness T} + \text{the initial distance} - \text{the final distance.}$$

A difference X between the measured thickness and the desired thickness of the wafer 6 within the to-be-thinned starting region 64 of the die 61 can be controlled to be very small (such as smaller than $2\mu m$). In some embodiments, the difference X is smaller than $6\mu m$. In some embodiments, the difference X is smaller than $4\mu m$. In some embodiments, the difference X is smaller than $2\mu m$.

In some embodiments, the system for localized wafer thinning 1 of the present invention further comprises a distance measuring apparatus (not shown in Figure), wherein the distance measuring apparatus is disposed above the bottom surface 63 of the wafer 6 (for example, the distance measuring apparatus is disposed next to the laser apparatus 4). Before performing localized laser thinning processing of the present invention on the bottom surface 63 of the wafer 6 within the to-be-thinned starting region 64 of each of the plurality of dies 61 by the laser apparatus 4, the distance measuring apparatus is moved to a measuring position above the bottom surface 63 of the wafer 6 (for example, the measuring position is above one point of the bottom surface 63 of the wafer 6, wherein the one point is within a to-be-thinned starting region 64 of a die 61). And then the distance measuring apparatus measures an initial distance between the distance measuring apparatus and the one point of the bottom surface 63 of the wafer 6. And then the distance measuring apparatus is moved away. After performing localized laser thinning processing of the present invention on the bottom surface 63 of the wafer 6 within the to-be-thinned starting region 64 of each of the plurality of dies 61, the distance measuring apparatus is moved to a plurality of final measuring positions respectively. Each final measuring position is above a to-be-thinned starting region 64 of one die 61 (the plurality of final measuring positions is corresponding to the to-be-thinned starting region 64 of each of the plurality of dies 61 respectively); that is, after performing localized laser thinning processing of the present invention, each final measuring position is above a bottom surface 76 of a backside trench 75 of one die 61. And then the distance measuring apparatus measures a plurality of final distances between the distance measuring apparatus and the bottom surface 76 of the backside trench 75 of each of the plurality of dies 61 respectively. Suppose there are N dies 61 ($1^{th}$ die 61, $2^{th}$ die 61, ... , $N^{th}$ die 61) and N final distances ($1^{th}$ final distance, $2^{th}$ final distance, ... , $N^{th}$ final distance) are measured. N measured thicknesses ($1^{th}$ measured thickness, $2^{th}$ measured thickness, ..., $N^{th}$ measured thickness) can be calculated. Since, the wafer 6 originally has the uniform thickness T; hence, for the $i^{th}$ die 61, the $i^{th}$ measured thickness of the wafer 6 can be calculated as follows:

$$\text{the } i^{th} \text{ measured thickness} =$$

$$\text{the uniform thickness T} + \text{the initial distance} - \text{the } i^{th} \text{ final distance,}$$

wherein $i = 1 ... N$.

For the $i^{th}$ die 61, wherein $i = 1 ... N$, the $i^{th}$ difference X between the $i^{th}$ measured thickness and the desired thickness of the wafer 6 within the to-be-thinned starting region 64 of the $i^{th}$ die 61 can be controlled to be very small (such as smaller than $2\mu m$). A variation of the N measured thicknesses ($1^{th}$ measured thickness, $2^{th}$ measured thickness, ... , $N^{th}$ measured thickness) of the wafer 6 can also be controlled to be very small (such as smaller than $2\mu m$). In some embodiments, the variation of the N measured thicknesses is smaller than $6\mu m$. In some embodiments, the variation of the N measured thicknesses is smaller than $4\mu m$. In some embodiments, the variation of the N measured thicknesses is smaller than $2\mu m$.

Please also refer to Figure 24, which shows a cross-sectional schematic view of the wafer taken along the E-E' section line in Figure 22 after the wafer has been locally thinned within the to-be-thinned starting region of the die by localized laser thinning processing of the present invention. In Figure 24, the plurality of dies 61 at least includes a first die 611, a second die 612, a third die 613, a fourth die 614 and a fifth die 615. The first die 611 has a first backside trench 751;

the second die 612 has a second backside trench 752; the third die 613 has a third backside trench 753; the fourth die 614 has a fourth backside trench 754; the fifth die 615 has a fifth backside trench 755. The first die 611 has a desired thickness D1; the second die 612 has a desired thickness D2; the third die 613 has a desired thickness D3; the fourth die 614 has a desired thickness D4; the fifth die 615 has a desired thickness D5; wherein, in current embodiment, the desired thickness D1 = desired thickness D2 = desired thickness D3 = desired thickness D4 = desired thickness D5 = desired thickness D.

In some embodiments, the desired thicknesses D1, D2, D3, D4, D5 may be all different. In some other embodiments, some of the desired thicknesses D1, D2, D3, D4, D5 may be the same, some may be different (for example, the desired thicknesses D1=D2, the desired thicknesses D3=D4, the desired thicknesses D1, D3 and D5 are all different.

In the embodiment of Figure 24, in any two adjacent dies 61, for example, the first die 611 and the second die 612 are adjacent, the first die 611 has only one to-be-thinned starting region 64 (not shown in Figure) which defines a region occupied by an opening of the first backside trench 751 of the first die 611; the second die 612 has only one to-be-thinned starting region 64 (not shown in Figure) which defines a region occupied by an opening of the second backside trench 752 of the second die 612. The opening of the first backside trench 751 of the first die 611 and the opening of the second backside trench 752 of the second die 612 are adjacent; that is, the to-be-thinned starting region 64 (not shown in Figure) of the first die 611 and the to-be-thinned starting region 64 (not shown in Figure) of the second die 612 are adjacent. Hence, a gap between the opening of the first backside trench 751 of the first die 611 and the opening of the second backside trench 752 of the second die 612 is a gap between the to-be-thinned starting region 64 (not shown in Figure) of the first die 611 and the to-be-thinned starting region 64 (not shown in Figure) of the second die 612. In any two adjacent dies 61, there is a gap between an opening of a backside trench of one of the two adjacent dies 61 and an opening of a backside trench of the other one of the two adjacent dies 61; in some embodiments, the gap is greater than $100\mu$m; in some other embodiments, the gap is greater than $120\mu$m; in some other embodiments, the gap is greater than $150\mu$m; in some other embodiments, the gap is greater than $170\mu$m; in some other embodiments, the gap is greater than $200\mu$m; in some other embodiments, the gap is greater than $250\mu$m.

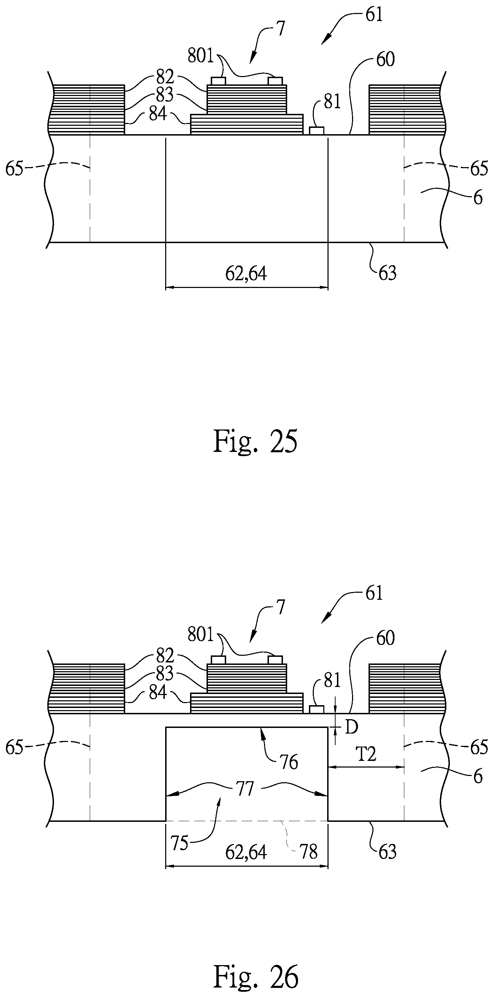

Please refer to Figure 25, which shows a cross-sectional schematic view of another embodiment of an interested region and a to-be-thinned starting region of a die before the wafer has been locally thinned by localized laser thinning processing of the present invention. In current embodiment, a wafer 6 includes a plurality of dies 61, wherein each of the plurality of dies 61 includes only one device 7, the device 7 of each of the plurality of dies 61 is a VCSEL (Vertical Cavity Surface Emitting Laser), wherein the interested feature of each of the plurality of dies 61 is determined to be the device 7 of each of the plurality of dies 61 on the top surface 60 of the wafer 6 respectively, wherein the to-be-thinned starting region 64 of each of the plurality of dies 61 is determined such that the interested feature of each of the plurality of dies 61 is within (but not identical to) the to-be-thinned starting region 64 of each of the plurality of dies 61 respectively (the to-be-thinned starting region 64 of each of the plurality of dies 61 covers an active region of the device 7 (the VCSEL) of each of the plurality of dies 61 on the top surface 60 of the wafer 6 respectively), wherein the interested region 62 of each of the plurality of dies 61 is (determined to be) identical to the to-be-thinned starting region 64 of each of the plurality of dies 61 respectively. In current embodiment, in each of the plurality of dies 61, the device 7 includes an upper-contact 801, a lower-contact 81, an upper-DBR (distributed Bragg reflector) 82, a quantum well region 83 and a lower-DBR 84, wherein the lower-DBR 84 is formed on the top surface 60 of the wafer 6, the quantum well region 83 is formed on the lower-DBR 84, the upper-DBR 82 is formed on the quantum well region 83, the upper-contact 801 is formed on the upper-DBR 82, the lower-contact 81 is formed on the top surface 60 of the wafer 6, wherein the upper-DBR 82 includes a plurality of upper layers; the quantum well region 83 includes a plurality of middle layers; the lower-DBR 84 includes a plurality of lower layers; wherein the device 7 (the VCSEL) does not include the upper-DBR 82, the quantum well region 83 and the lower-DBR 84 beyond the to-be-thinned starting region 64 (beyond the interested region 62), wherein the interested feature (the device 7 (the VCSEL)) of each of the plurality of dies 61 is within (but not identical to) the to-be-thinned starting region 64 of each of the plurality of dies 61 respectively and within (but not identical to) the interested region 62 of each of the plurality of dies 61 respectively. After so many layers (including the plurality of upper layers of the lower-DBR 84, the plurality of middle layers of the quantum well region 83 and the plurality of lower layers of the upper-DBR 82) formed on the top surface 60 of the wafer 6, the wafer 6 is suffered a huge stress.

If performing conventional wafer thinning process (such as, mechanical grinding or chemical mechanical planarization) on a bottom surface 63 of the wafer 6, then after the wafer 6 is thinned (globally), the wafer 6 becomes thinner. Since the wafer 6 becomes thinner so that it is more difficult for the wafer 6 to balance the huge stress caused by the many layers formed on the top surface 60 of the wafer 6. Therefore, the warpage of the wafer 6 becomes serious and even further causes the cracking of the edge of the wafer 6. Moreover, the warpage of the wafer 6 caused by the stress is less obvious when a diameter of the wafer 6 is less than 3 inches, while the warpage of the wafer 6 caused by the stress is much more significant when the diameter of the wafer 6 is greater than or equal to 4 inches, 6 inches, 8 inches or even greater.

In the embodiment of Figure 25, the interested feature of each of the plurality of dies 61 includes (is determined to include) the device 7 of each of the plurality of dies 61 respectively; the to-be-thinned starting region 64 of each of the plurality of dies 61 is determined such that the interested feature of each of the plurality of dies 61 is within (but not identical to) the to-be-thinned starting region 64 of each of the plurality of dies 61 respectively (the to-be-thinned starting region 64 of each of the plurality of dies 61 covers an active region of the device 7 of each of the plurality of dies 61 on the top surface 60 of the wafer 6 respectively); and the interested region 62 of each of the plurality of dies 61 is (determined to be) identical to the to-be-thinned starting region 64 of each of the plurality of dies 61 respectively. Please also refer to Figure 26, which shows a cross-sectional schematic view of the die in Figure 25 after the wafer has been locally thinned within the to-be-thinned starting region of the die by localized laser thinning processing of the present invention. After performing localized laser thinning processing of the present invention on the bottom surface 63 of the wafer 6 within the to-be-thinned starting region 64 of each of the plurality of dies 61, a backside trench 75 of each of the plurality of dies 61 is formed on the backside of the wafer 6. The backside trench 75 of each of the plurality of dies 61 has a bottom surface 76, a sidewall 77 and an opening 78 on the bottom surface 63 of the wafer 6. In current embodiment, the interested region 62 of each of the plurality of dies 61 is (determined to be) identical to the to-be-thinned starting region 64 of each of the plurality of dies 61 respectively; hence a shape of the sidewall 77 of the backside trench 75 of each of the plurality of dies 61 is upright. A region occupied by the opening 78 of the backside trench 75 of each of the plurality of dies 61 on the bottom surface 63 of the wafer 6 is identical to the to-be-thinned starting region 64 of each of the plurality of dies 61 respectively. The interested region 62 of each of the plurality of dies 61 is identical to a region occupied by the bottom surface 76 of the backside trench 75 of each of the plurality of dies 61 respectively. The opening 78 of the backside trench 75 of each of the plurality of dies 61 and the bottom surface 76 of the backside trench 75 of each of the plurality of dies 61 have an identical shape and an identical area respectively. In current embodiment, the wafer 6 has a desired thickness D within the interested region 62 of each of the plurality of dies 61; while the wafer 6 has the uniform thickness T beyond the interested region 62 (the to-be-thinned starting region 64) of each of the plurality of dies 61. Hence, the mechanical strength of the wafer 6 is enhanced. The structure of the wafer 6 is sufficient to balance the stress caused by the many layers formed on the top surface 60 of the wafer 6. There will be no such a problem of the warpage of the wafer 6.

In the embodiment of Figure 26, after the wafer 6 has been locally thinned by localized laser thinning processing of the present invention, if the wafer 6 is cut into separated independent dies (chips) along these dotted cut lines 65, each of the separated independent dies (chips) 61 may have a sidewall 77 of the backside trench 75. A thickness of the sidewall 77 of the backside trench 75 of each of the separated independent dies (chips) 61 is a little bit smaller than a thickness T2. The structure of the wafer 6 in a single separated independent die (chip) 61 is sufficient to balance the stress caused by the many layers formed on the top surface 60 of the wafer 6. Therefore, not only the mechanical strength of the whole wafer 6 is enhanced, but also the mechanical strength of each of the separated independent dies (chips) 61 is enhanced after the plurality of dies 61 is cut into the separated independent dies (chips) 61.

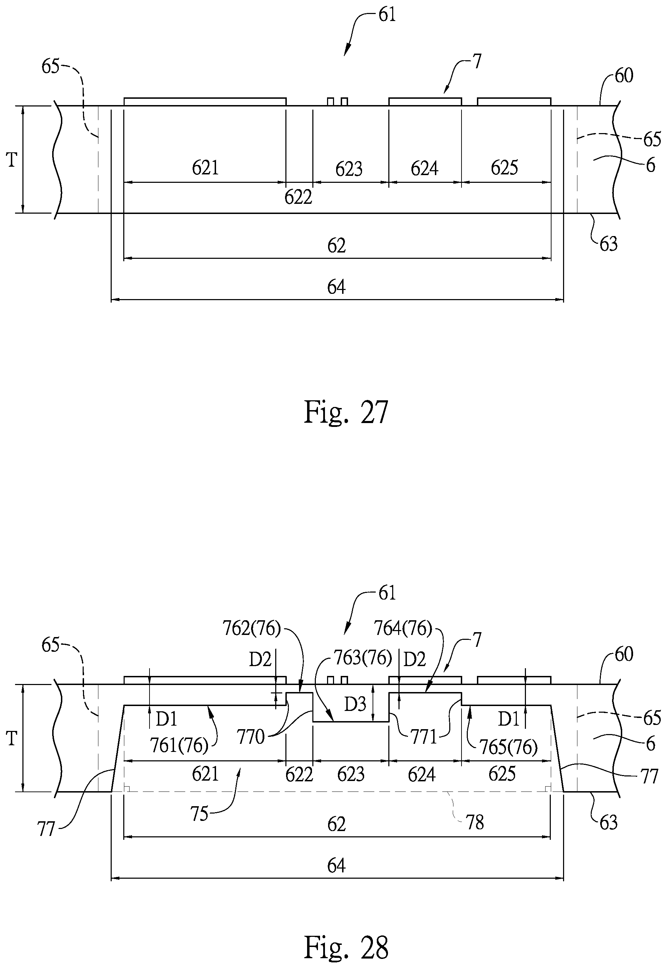

Please refer to Figure 27, which shows a cross-sectional schematic view of another embodiment of an interested region and a to-be-thinned starting region of a die before the wafer has been locally thinned by localized laser thinning processing of the present invention. In current embodiment, a wafer 6 includes a plurality of dies 61, wherein each of the plurality of dies 61 includes only one device 7 (the device 7 is not a power device as shown in Figure 3), wherein the interested feature of each of the plurality of dies 61 is determined to be the device 7 of each of the plurality of dies 61 on the top surface 60 of the wafer 6 respectively, wherein the to-be-thinned starting region 64 of each of the plurality of dies 61 is determined such that the interested feature of each of the plurality of dies 61 is within (but not identical to) the to-be-thinned starting region 64 of each of the plurality of dies 61 respectively (the to-be-thinned starting region 64 of each of the plurality of dies 61 covers an active region of the device 7 of each of the plurality of dies 61 on the top surface 60 of the wafer 6 respectively), wherein the interested region 62 of each of the plurality of dies 61 is (determined to be) within (but not identical to) the to-be-thinned starting region 64 of each of the plurality of dies 61 respectively. In current embodiment, in each of the plurality of dies 61, the interested region 62 of includes a first interested sub-region 621, a second interested sub-region 622, a third interested sub-region 623, a fourth interested sub-region 624 and a fifth interested sub-region 625. Please also refer to Figure 28, which shows a cross-sectional schematic view of the die in Figure 27 after the wafer has been locally thinned within the to-be-thinned starting region of the die by localized laser thinning processing of the present invention. After performing localized laser thinning processing of the present invention on the bottom surface 63 of the wafer 6 within the to-be-thinned starting region 64 of each of the plurality of dies 61, a backside trench 75 of each of the plurality of dies 61 is formed on the backside of the wafer 6. The backside trench 75 of each of the plurality of dies 61 has a bottom surface 76 (including a first bottom surface 761, a second bottom surface 762, a third bottom surface 763, a fourth bottom surface 764 and a fifth bottom surface 765), a main sidewall 77, a first sidewall 770, a second sidewall 771 and an opening 78 on the bottom surface 63 of the wafer 6. In current embodiment, the interested region 62 of each of the plurality of dies 61 is (determined to be) within (but not identical to) the to-be-thinned starting region 64 of each of the plurality of dies 61 respectively; and a shape of the main sidewall 77 of the backside trench 75 of each of the plurality of dies 61 is (determined to be) tapered (the tapered shape of the main sidewall 77 of the backside trench 75 can be approached by a combination of many stepped shapes). A shape of the first sidewall 770 and a shape of the second sidewall 771 of the backside trench 75 of each of the plurality of dies 61 are determined to be upright. A region occupied by the opening 78 of the backside trench 75 of each of the plurality of dies 61 on the bottom surface 63 of the wafer 6 is identical to the to-be-thinned starting region 64 of each of the plurality of dies 61 respectively. The interested region 62 of each of the plurality of dies 61 is identical to a region occupied by the bottom surface 76 (including the first bottom surface 761, the second bottom surface 762, the third bottom surface 763, the fourth bottom surface 764 and the fifth bottom surface 765) of the backside trench 75 of each of the plurality of dies 61 respectively. The region occupied by the opening 78 of the backside trench 75 of each of the plurality of dies 61 is wider than the region occupied by the bottom surface 76 of the backside trench 75 of each of the plurality of dies 61 respectively. In current embodiment, the wafer 6 has a desired thickness D1 within the first interested sub-region 621 and the fifth interested sub-region 625 of each of the plurality of dies 61; the wafer 6 has a desired thickness D2 within the second interested sub-region 622 and the fourth interested sub-region 624 of each of the plurality of dies 61; the wafer 6 has a desired thickness D3 within the third interested sub-region 623 of each of the plurality of dies 61; wherein the desired thickness D3 is greater than the desired thickness D1; while the desired thickness D1 is greater than the desired thickness D2.

The method for localized wafer thinning of the present invention does not require photolithographic processes (such as forming a photoresist on the bottom surface 63 of the wafer 6, and then using a photo mask to expose and develop such that the to-be-thinned starting region 64 of each of the plurality of dies 61 is exposed, and then performing dry etching or wet etching to form the backside trench 75 of each of the plurality of dies 61). If the user wants to form the backside trench 75 of the embodiment of Figure 28 through photolithographic processes, then it will require many and complicated procedures to achieve it. In comparison, using the method for localized wafer thinning of the present invention to form the backside trench 75 of the embodiment of Figure 28 is very simple. Using the method for localized wafer thinning of the present invention, not only can the backside trench 75 with complex shapes be simply formed, but the depth of the backside trench 75 can also be simply controlled. Furthermore, when using photolithographic processes to form the backside trench 75, if the wafer 6 is made of SiC (very hard material), the etching rate is very slow. That means that it will take much more time to etch the SiC wafer 6 to form the backside trench 75. In comparison, using the method for localized wafer thinning of the present invention to form the backside trench 75 is very fast. In another example, when using photolithographic processes to form the backside trench 75, if the wafer 6 is made of GaAs (the material is not as hard SiC), the etching rate is will be faster than the etching rate when etching SiC. However, in comparison, using the method for localized wafer thinning of the present invention to form the backside trench 75 is still faster (than etching GaAs through photolithographic processes) than the etching rate when etching GaAs by photolithographic processes. Moreover, during etching GaAs, a variation of the depth of the backside trenches 75 will be affected by the temperature gradient and the concentration gradient of the etching liquid/gas flow. Therefore, the variation of the depth of the backside trenches 75 will be considerably large.

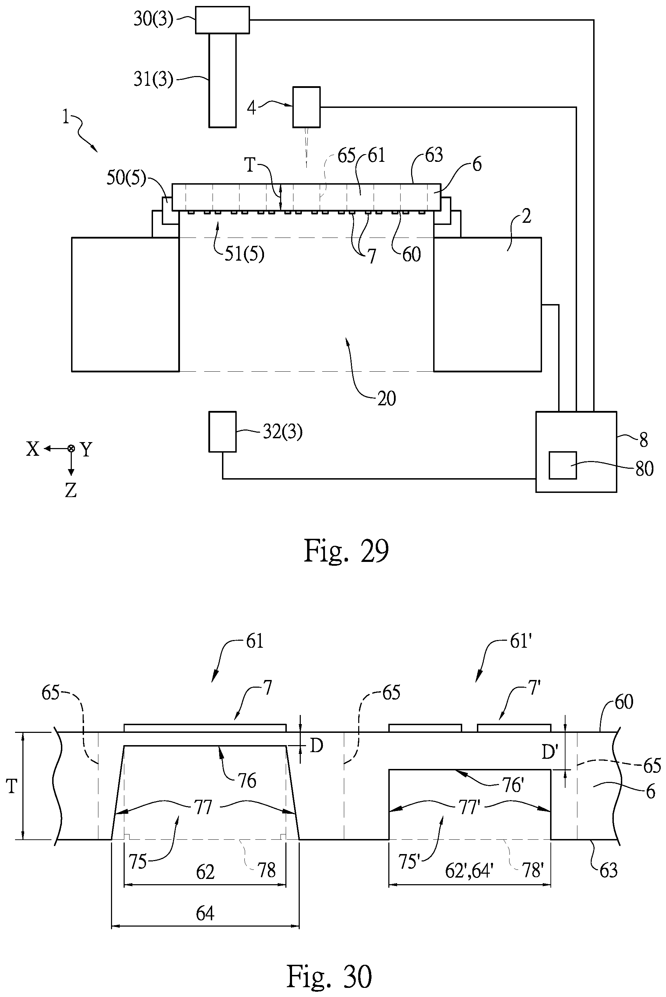

Please refer to Figure 29, which shows a cross-sectional schematic view of another embodiment of a system for localized wafer thinning of the present invention. The main structure of the embodiment of Figure 29 is basically the same as the structure of the embodiment of Figure 1, except that the wafer 6 is transparent, the image capture device 30 of the image capturing apparatus 3 is disposed above the bottom surface 63 of the wafer 6 (for example, the image capture device 30 is disposed beside the laser apparatus 4), the light source 32 of the image capturing apparatus 3 is disposed under the hollow center portion 20 of the motion driving apparatus 2, the light source 32 is not a coaxial light source. The light emitted by the light source 32 can propagate through the hollow center portion 20 of the motion driving apparatus 2 and the hollow center portion 51 of the carrying apparatus 5 to illuminate at least one portion of the wafer 6 (for example, at least one die 61), and so that the image capture device 30 of the image capturing apparatus 3 can capture image(s) of at least one die 61 (the outline of the device 7 of the at least one die 61) from the bottom surface 63 of the wafer 6 (since the wafer 6 is transparent). In some other embodiments, the light emitted by the light source 32 can illuminate the whole wafer 6 so that the image capture device 30 of the image capturing apparatus 3 can capture image(s) of each of the plurality of dies 61 (the outline of the device 7 of each of the plurality of dies 61) from the bottom surface 63 of the wafer 6 (since the wafer 6 is transparent).

In some embodiments, (not shown in Figure) the wafer 6 is transparent, the image capture device 30 of the image capturing apparatus 3 is disposed under the hollow center portion 20 of the motion driving apparatus 2, the light source 32 of the image capturing apparatus 3 is not a coaxial light source, the light source 32 is disposed above the bottom surface 63 of the wafer 6 (for example, the light source 32 is a ring light source disposed between the bottom surface 63 of the wafer 6 and the laser apparatus 4; or the light source 32 is disposed beside the laser apparatus 4).

In some other embodiments, (not shown in Figure) the wafer 6 is transparent, the image capture device 30 and the light source 32 of the image capturing apparatus 3 are disposed above the bottom surface 63 of the wafer 6 (for example, the image capture device 30 and the light source 32 are disposed beside the laser apparatus 4).

In some embodiments, the hollow center portion 51 of the carrying apparatus 5 may be not hollow, wherein the hollow center portion 51 of the carrying apparatus 5 may be made by a transparent material, such as glass.

Please refer to Figure 30, which shows a cross-sectional schematic view of an embodiment of two dies after the wafer has been locally thinned by localized laser thinning processing of the present invention. The main structure of the embodiment of Figure 30 is basically the same as the structure of the embodiment of Figure 18, except that the wafer 6 includes a plurality of dies 61 and a plurality of dies 61', wherein each of the plurality of dies 61 includes a device 7 and each of the plurality of dies 61' includes a device 7', wherein an interested feature of each of the plurality of dies 61 is determined to be the device 7 of each of the plurality of dies 61 respectively; while an interested feature' of each of the plurality of dies 61' is determined to be the device 7' of each of the plurality of dies 61' respectively; wherein a to-be-thinned starting region 64 of each of the plurality of dies 61 is determined such that the interested feature of each of the plurality of dies 61 is within (but not identical to) the to-be-thinned starting region 64 of each of the plurality of dies 61 respectively; while a to-be-thinned starting region 64' of each of the plurality of dies 61' is determined to be identical to the interested feature' of each of the plurality of dies 61' respectively; wherein an interested region 62 of each of the plurality of dies 61 is (determined to be) within (but not identical to) the to-be-thinned starting region 64 of each of the plurality of dies 61 respectively; while an interested region 62' of each of the plurality of dies 61' is (determined to be) identical to the to-be-thinned starting region 64' of each of the plurality of dies 61' respectively. In current embodiment, after performing localized laser thinning processing of the present invention on the bottom surface 63 of the wafer 6 within the to-be-thinned starting region 64 of each of the plurality of dies 61 and the to-be-thinned starting region 64' of each of the plurality of dies 61' respectively, a backside trench 75 of each of the plurality of dies 61 and a backside trench 75' of each of the plurality of dies 61' are formed on the backside of the wafer 6 respectively; wherein the backside trench 75 of each of the plurality of dies 61 has a bottom surface 76, a sidewall 77 and an opening 78 on the bottom surface 63 of the wafer 6; wherein the backside trench 75' of each of the plurality of dies 61' has a bottom surface 76', a sidewall 77' and an opening 78' on the bottom surface 63 of the wafer 6; wherein a shape of the sidewall 77 of the backside trench 75 of each of the plurality of dies 61 is (determined to be) tapered (the tapered shape of the sidewall 77 of the backside trench 75 can be approached by a combination of many stepped shapes); wherein a region occupied by the opening 78 of the backside trench 75 of each of the plurality of dies 61 on the bottom surface 63 of the wafer 6 is identical to the to-be-thinned starting region 64 of each of the plurality of dies 61 respectively; wherein the interested region 62 of each of the plurality of dies 61 is identical to a region occupied by the bottom surface 76 of the backside trench 75 of each of the plurality of dies 61 respectively; wherein a shape of the sidewall 77' of the backside trench 75' of each of the plurality of dies 61' is upright; wherein a region occupied by the opening 78' of the backside trench 75' of each of the plurality of dies 61' on the bottom surface 63 of the wafer 6 is identical to the to-be-thinned starting region 64' of each of the plurality of dies 61' respectively; wherein the interested region 62' of each of the plurality of dies 61' is identical to a region occupied by the bottom surface 76' of the backside trench 75' of each of the plurality of dies 61' respectively; wherein the opening 78' of the backside trench 75' of each of the plurality of dies 61' and the bottom surface 76' of the backside trench 75' of each of the plurality of dies 61' have an identical shape and an identical area respectively; wherein the wafer 6 has a desired thickness D within the interested region 62 of each of the plurality of dies 61; while the wafer 6 has a desired thickness D' within the interested region 62' of each of the plurality of dies 61', wherein the desired thickness D is not equal to the desired thickness D' (in current embodiment, the desired thickness D' is greater than the desired thickness D).

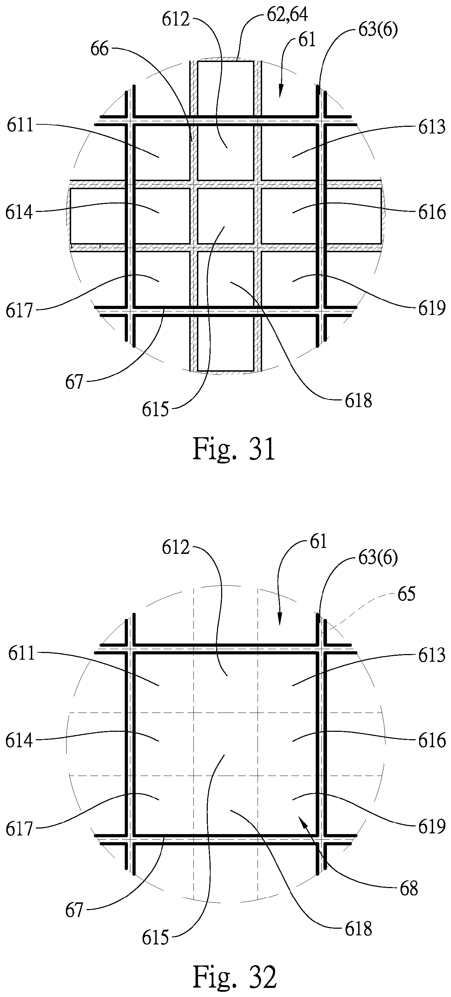

Please refer to Figure 31, which shows a schematic partial enlarged view of another embodiment of a bottom surface of a wafer before the wafer has been locally thinned by localized laser thinning processing of the present invention. In current embodiment, a wafer 6 includes a plurality of dies 61; the plurality of dies 61 includes a first die 611, a second die 612, a third die 613, a fourth die 614, a fifth die 615, a sixth die 616, a seventh die 617, an eighth die 618, a ninth die 619 and some other dies 61. The dotted cut lines 65 in Figure 31 are the boundaries of each of the plurality of dies 61. An interested region 62 and a to-be-thinned starting region 64 of each of the first die 611, the second die 612, the third die 613, the fourth die 614, the fifth die 615, the sixth die 616, the seventh die 617, the eighth die 618, the ninth die 619 and some other dies 61 are determined and shown in Figure 31. After executing the Step C (at least after the to-be-thinned starting region 64 of each of the dies 61 is determined), the method for localized wafer thinning of the present invention further comprises a following step of: dividing plurality of dies 61 into some die clusters 68, wherein each of the die clusters 68 includes at least two dies 61; and wherein, in each of the die clusters 68, any one die 61 is adjacent to at least one other die 61. One of the die clusters 68 is shown in the center of Figure 31. The die cluster 68 in the center of Figure 31 includes 9 dies 61 (including the first die 611, the second die 612, the third die 613, the fourth die 614, the fifth die 615, the sixth die 616, the seventh die 617, the eighth die 618 and the ninth die 619); wherein, in the die cluster 68, any two adjacent dies 61 has a boundary region 66 between the at least one to-be-thinned starting regions 64 of the two adjacent dies 61; for example, the first die 611 and the second die 612 are two adjacent dies 61, there is a boundary region 66 between the at least one to-be-thinned starting region 64 of the first die 611 and the at least one to-be-thinned starting region 64 of the second die 612. Please also refer to Figure 32, which shows a schematic view of the bottom surface of the wafer in Figure 31 after the wafer has been locally thinned by localized laser thinning processing of the present invention. In current embodiment, in the Step F of the method for localized wafer thinning of the present invention, the laser apparatus 4 performs localized laser thinning processing on the bottom surface 63 of the wafer 6 not only within the at least one to-be-thinned starting region 64 of each of the plurality of dies 61, but also within a boundary region 66 between the at least one to-be-thinned starting regions 64 of any two adjacent dies 61 of each of the die clusters 68 respectively, such that the wafer 6 is locally thinned within the at least one to-be-thinned starting region 64 of each of the plurality of dies 61 and within the boundary region 66 between the at least one to-be-thinned starting regions 64 of the any two adjacent dies 61 of each of the die clusters 68 respectively (in current embodiment, in the die cluster 68 shown in the center of Figure 31, the wafer 6 is locally thinned within the at least one to-be-thinned starting region 64 of the 9 dies 611-619, the boundary region 66 between the at least one to-be-thinned starting regions 64 of the two dies 611, 612, the boundary region 66 between the at least one to-be-thinned starting regions 64 of the two dies 612, 613, the boundary region 66 between the at least one to-be-thinned starting regions 64 of the two dies 611, 614, the boundary region 66 between the at least one to-be-thinned starting regions 64 of the two dies 612, 615, the boundary region 66 between the at least one to-be-thinned starting regions 64 of the two dies 613, 616, the boundary region 66 between the at least one to-be-thinned starting regions 64 of the two dies 614, 615, the boundary region 66 between the at least one to-be-thinned starting regions 64 of the two dies 615, 616, the boundary region 66 between the at least one to-be-thinned starting regions 64 of the two dies 614, 617, the boundary region 66 between the at least one to-be-thinned starting regions 64 of the two dies 615, 618, the boundary region 66 between the at least one to-be-thinned starting regions 64 of the two dies 616, 619, the boundary region 66 between the at least one to-be-thinned starting regions 64 of the two dies 617, 618, the boundary region 66 between the at least one to-be-thinned starting regions 64 of the two dies 618, 619), so as to form an unseparated backside trench 67 of each of the die clusters 68, wherein the unseparated backside trench 67 of each of the die clusters 68 has an opening; wherein, in any one of the die clusters 68, a region occupied by the opening of the unseparated backside trench 67 of the one of the die clusters 68 is defined by a combined region of the at least one to-be-thinned starting region 64 of each of the dies 61 within the one of the die clusters 68 and the boundary region 66 between the at least one to-be-thinned starting regions 64 of the any two adjacent dies 61 of the one of the die clusters 68 respectively (in current embodiment, in the die clusters 68 shown in the center of Figure 31, the opening of the unseparated backside trench 67 is shown in Figure 32). A desired thickness within the boundary region 66 between the at least one to-be-thinned starting regions 64 of the any two adjacent dies 61 of the one of the die clusters 68 may be the same as the desired thickness within the interested region 62 of the any two adjacent dies 61 of the one of the die clusters 68 or may be different from the desired thickness within the interested region 62 of the any two adjacent dies 61 of the one of the die clusters 68 (in current embodiment, the desired thickness within the boundary region 66 between the at least one to-be-thinned starting regions 64 of the any two adjacent dies 61 of the one of the die clusters 68 is the same as the desired thickness within the interested region 62 of the any two adjacent dies 61 of the one of the die clusters 68).

In some embodiments, the wafer 6 includes a plurality of dies 61, wherein the plurality of dies 61 has N dies 61 (for example, N = 80, i.e. the wafer 6 includes 80 dies 61); after executing the Step C (at least after the to-be-thinned starting region 64 of each of the dies 61 is determined), the method for localized wafer thinning of the present invention further comprises a following step of: dividing M dies 61 of the N dies 61 into at least two die clusters 68, wherein $N \geq M \geq 4$, N and M are positive integers, wherein any two die clusters 68 include P dies 61 and Q dies 61 of the M dies 61 respectively, wherein $M \geq (P + Q) \geq 4$, $P = Q$ or $P \neq Q$, P and Q are positive integers; that is, any two die clusters 68 may include the same numbers of dies 61 or different numbers of dies 61; wherein, in each of the die clusters 68, any one die 61 is adjacent to at least one other die 61. For example, when $N > M \geq 4$, the M dies 61 are among some of the N dies 61; while when $N = M \geq 4$, the M dies 61 are the N dies 61. The M dies 61 of the N dies 61 may be divided into two die clusters 68, three die clusters 68 or more die clusters 68. For example, when N = 97, M = 97, the M (97) dies may be divided into nine die clusters 68 (each of the nine die clusters 68 includes nine dies 61) and four die clusters 68 (each of the four die clusters 68 includes four dies 61). Another example, when N = 97, M = 81, the M (81) dies may be divided into six die clusters 68 (each of the six die clusters 68 includes nine dies 61) and three die clusters 68 (each of the three die clusters 68 includes nine dies 61), while the rest of 16 dies 61 of the N (97) dies 61 are not divided into any die cluster 68. One more example, when N = 97, M = 81, the M (81) dies may be divided into five die clusters 68 (each of the five die clusters 68 includes nine dies 61), three die clusters 68 (each of the three die clusters 68 includes eight dies 61) and two die clusters 68 (each of the two die clusters 68 includes six dies 61), while the rest of 16 dies 61 of the N (97) dies 61 are not divided into any die cluster 68.

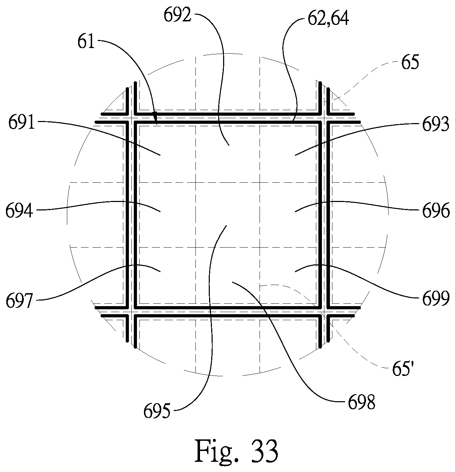

Please refer to Figure 33, which shows a schematic partial enlarged view of another embodiment of a bottom surface of a wafer after the wafer has been locally thinned by localized laser thinning processing of the present invention. In current embodiment, a wafer 6 includes a plurality of dies 61, wherein each of the plurality of dies 61 includes 9 sub-dies (including a first sub-die 691, a second sub-die 692, a third sub-die 693, a fourth sub-die 694, a fifth sub-die 695, a sixth sub-die 696, a seventh sub-die 697, an eighth sub-die 698 and a ninth sub-die 699); wherein, in each of the plurality of dies 61, the dotted cut lines 65' are the boundaries of the 9 sub-dies (including the first sub-die 691, the second sub-die 692, the third sub-die 693, the fourth sub-die 694, the fifth sub-die 695, the sixth sub-die 696, the seventh sub-die 697, the eighth sub-die 698 and the ninth sub-die 699); wherein each of the 9 sub-dies includes at least one device (not shown in Figure) formed on the top surface 60 of the wafer 6; wherein, in each of the plurality of dies 61, an interested feature is determined to be an unseparated region occupied by a combination of the at least one device of each of the 9 sub-dies respectively; wherein, in each of the plurality of dies 61, an to-be-thinned starting region 64 is determined such that the interested feature is within (but not identical to) the to-be-thinned starting region 64; wherein, in each of the plurality of dies 61, an interested region 62 is (determined to be) identical to the to-be-thinned starting region 64. After performing localized laser thinning processing of the present invention on the bottom surface 63 of the wafer 6 within the to-be-thinned starting region 64 of each of the plurality of dies 61, a backside trench 75 of each of the plurality of dies 61 is formed on the backside of the wafer 6. In each of the plurality of dies 61, the backside trench 75 has a bottom surface, a sidewall and an opening on the bottom surface 63 of the wafer 6, a shape of the sidewall of the backside trench 75 is upright, a region occupied by the opening of the backside trench 75 on the bottom surface 63 of the wafer 6 is identical to the to-be-thinned starting region 64, the interested region 62 is identical to a region occupied by the bottom surface of the backside trench 75, wherein the dotted cut lines 65' (the boundaries of the 9 sub-dies) are within the region occupied by the bottom surface of the backside trench 75. The wafer 6 has a desired thickness (not shown in Figure) within the interested region 62 of each of the plurality of dies 61. In current embodiment, the wafer 6 will be cut into a plurality of separated independent sub-dies along these dotted cut lines 65'. In some embodiments, the wafer 6 will be cut into separated independent dies 61 along these dotted cut lines 65 and then each of the separated independent dies 61 will be cut into 9 separated independent sub-dies along these dotted cut lines 65'.

In the embodiments of Figures 8-10, 21 and 26, a shape of the sidewall surface 77 of the backside trench 75 of each of the plurality of dies 61 is upright (perpendicular to the bottom surface 63 of the wafer 6); while in the embodiment of Figure 14, a shape of the sidewall surface 77 of the backside trench 75 of each of the plurality of dies 61 is tapered (not perpendicular to the bottom surface 63 of the wafer 6), but steep (that is, a slope of the sidewall surface 77 is great; for example, a slope of the sidewall surface 77 is equal to 4, 5, 6, 7, 8, 9, or 10). In some other embodiments, a shape of the sidewall surface 77 of the backside trench 75 of each of the plurality of dies 61 is tapered, but not so steep (for example, a slope of the sidewall surface 77 is equal to 3, 2, or 1). In the embodiment of Figure 16, a shape of the sidewall surface 77 of the backside trench 75 of each of the plurality of dies 61 is stepped. In some other embodiments, a shape of the sidewall surface 77 of the backside trench 75 of each of the plurality of dies 61 may be a combination of stepped and tapered.

The wafer 6 has the desired thickness D within the interested region 62 of each of the plurality of dies 61. In some embodiments, the desired thickness D is greater than or equal to $200\mu m$ and smaller than or equal to $300\mu m$. In some other embodiments, the desired thickness D is greater than or equal to $100\mu m$ and smaller than or equal to $200\mu m$. In some other embodiments, the desired thickness D is greater than or equal to $50\mu m$ and smaller than or equal to $100\mu m$. In some embodiments, the desired thickness D is greater than or equal to $20\mu m$ and smaller than or equal to $50\mu m$. In some other embodiments, the desired thickness D is greater than or equal to $10\mu m$ and smaller than or equal to $20\mu m$.

In the embodiment of Figure 28, the wafer 6 has the desired thickness D2 within the second interested sub-region 622 and the fourth interested sub-region 624 of each of the plurality of dies 61. In some embodiments, the desired thickness D2 is greater than or equal to $200\mu m$ and smaller than or equal to $300\mu m$. In some other embodiments, the desired thickness D2 is greater than or equal to $100\mu m$ and smaller than or equal to $200\mu m$. In some other embodiments, the desired thickness D2 is greater than or equal to $50\mu m$ and smaller than or equal to $100\mu m$. In some embodiments, the desired thickness D2 is greater than or equal to $20\mu m$ and smaller than or equal to $50\mu m$. In some other embodiments, the desired thickness D2 is greater than or equal to $10\mu m$ and smaller than or equal to $20\mu m$. In some embodiments, the desired thickness D2 is greater than or equal to $5\mu m$ and smaller than or equal to $10\mu m$. In some embodiments, the desired thickness D2 is greater than or equal to $2\mu m$ and smaller than or equal to $5\mu m$. In some embodiments, the desired thickness D2 is greater than or equal to $1\mu m$ and smaller than or equal to $2\mu m$. In some embodiments, the desired thickness D2 is greater than or equal to $500nm$ and smaller than or equal to $1\mu m$. In some embodiments, the desired thickness D2 is greater than or equal to $200nm$ and smaller than or equal to $500nm$. In some embodiments, the desired thickness D2 is greater than or equal to $100nm$ and smaller than or equal to $200nm$.

In some embodiments, the interested region 62 or the second interested sub-region 622 has a shape of a circle, wherein a diameter of the circle is greater than or equal to $10000\mu m$ and smaller than or equal to $15000\mu m$. In some other embodiments, the diameter of the circle is greater than or equal to $5000\mu m$ and smaller than or equal to $10000\mu m$. In some other embodiments, the diameter of the circle is greater than or equal to $2000\mu m$ and smaller than or equal to $5000\mu m$. In some other embodiments, the diameter of the circle is greater than or equal to $1000\mu m$ and smaller than or equal to $2000\mu m$. In some other embodiments, the diameter of the circle is greater than or equal to $500\mu m$ and smaller than or equal to $1000\mu m$. In some other embodiments, the diameter of the circle is greater than or equal to $200\mu m$ and smaller than or equal to $500\mu m$. In some other embodiments, the diameter of the circle is greater than or equal to $120\mu m$ and smaller than or equal to $200\mu m$. In some other embodiments, the diameter of the circle is greater than or equal to $80\mu m$ and smaller than or equal to $120\mu m$. In some other embodiments, the diameter of the circle is greater than or equal to $30\mu m$ and smaller than or equal to $80\mu m$. In some other embodiments, the diameter of the circle is greater than or equal to $10\mu m$ and smaller than or equal to $30\mu m$. In some other embodiments, the diameter of the circle is greater than or equal to $5\mu m$ and smaller than or equal to $10\mu m$.

In some embodiments, the interested region 62 or the second interested sub-region 622 has a shape of an ellipse, wherein a minor axis of the ellipse is smaller than a major axis of the ellipse. In some embodiments, the minor axis of the ellipse is greater than or equal to $10000\mu m$ and smaller than or equal to $15000\mu m$, the major axis of the ellipse is smaller than or equal to $30000\mu m$. In some other embodiments, the minor axis of the ellipse is greater than or equal to $5000\mu m$ and smaller than or equal to $10000\mu m$, and the major axis of the ellipse is smaller than or equal to $20000\mu m$. In some other embodiments, the minor axis of the ellipse is greater than or equal to $2000\mu m$ and smaller than or equal to $5000\mu m$, and the major axis of the ellipse is smaller than or equal to $15000\mu m$. In some other embodiments, the minor axis of the ellipse is greater than or equal to $1000\mu m$ and smaller than or equal to $2000\mu m$, and the major axis of the ellipse is smaller than or equal to $6000\mu m$. In some other embodiments, the minor axis of the ellipse is greater than or equal to $500\mu m$ and smaller than or equal to $1000\mu m$, and the major axis of the ellipse is smaller than or equal to $3000\mu m$. In some

other embodiments, the minor axis of the ellipse is greater than or equal to 200μm and smaller than or equal to 500μm, and the major axis of the ellipse is smaller than or equal to 1500μm. In some other embodiments, the minor axis of the ellipse is greater than or equal to 120μm and smaller than or equal to 200μm, and the major axis of the ellipse is smaller than or equal to 600μm. In some other embodiments, the minor axis of the ellipse is greater than or equal to 80μm and smaller than or equal to 120μm, and the major axis of the ellipse is smaller than or equal to 360μm. In some other embodiments, the minor axis of the ellipse is greater than or equal to 30μm and smaller than or equal to 80μm, and the major axis of the ellipse is smaller than or equal to 240μm. In some other embodiments, the minor axis of the ellipse is greater than or equal to 10μm and smaller than or equal to 30μm, and the major axis of the ellipse is smaller than or equal to 90μm. In some other embodiments, the minor axis of the ellipse is greater than or equal to 5μm and smaller than or equal to 10μm, and the major axis of the ellipse is smaller than or equal to 30μm.

In some embodiments, the to-be-thinned starting region 64 has a shape of a circle, wherein a diameter of the circle is greater than or equal to 10000μm and smaller than or equal to 15000μm. In some other embodiments, the diameter of the circle is greater than or equal to 5000μm and smaller than or equal to 10000μm. In some other embodiments, the diameter of the circle is greater than or equal to 2000μm and smaller than or equal to 5000μm. In some other embodiments, the diameter of the circle is greater than or equal to 1000μm and smaller than or equal to 2000μm. In some other embodiments, the diameter of the circle is greater than or equal to 500μm and smaller than or equal to 1000μm. In some other embodiments, the diameter of the circle is greater than or equal to 200μm and smaller than or equal to 500μm. In some other embodiments, the diameter of the circle is greater than or equal to 120μm and smaller than or equal to 200μm. In some other embodiments, the diameter of the circle is greater than or equal to 80μm and smaller than or equal to 120μm. In some other embodiments, the diameter of the circle is greater than or equal to 30μm and smaller than or equal to 80μm. In some other embodiments, the diameter of the circle is greater than or equal to 10μm and smaller than or equal to 30μm. In some other embodiments, the diameter of the circle is greater than or equal to 5μm and smaller than or equal to 10μm.

In some embodiments, the to-be-thinned starting region 64 has a shape of an ellipse, wherein a minor axis of the ellipse is smaller than a major axis of the ellipse. In some embodiments, the minor axis of the ellipse is greater than or equal to 10000μm and smaller than or equal to 15000μm, the major axis of the ellipse is smaller than or equal to 30000μm. In some other embodiments, the minor axis of the ellipse is greater than or equal to 5000μm and smaller than or equal to 10000μm, and the major axis of the ellipse is smaller than or equal to 20000μm. In some other embodiments, the minor axis of the ellipse is greater than or equal to 2000μm and smaller than or equal to 5000μm, and the major axis of the ellipse is smaller than or equal to 15000μm. In some other embodiments, the minor axis of the ellipse is greater than or equal to 1000μm and smaller than or equal to 2000μm, and the major axis of the ellipse is smaller than or equal to 6000μm. In some other embodiments, the minor axis of the ellipse is greater than or equal to 500μm and smaller than or equal to 1000μm, and the major axis of the ellipse is smaller than or equal to 3000μm. In some other embodiments, the minor axis of the ellipse is greater than or equal to 200μm and smaller than or equal to 500μm, and the major axis of the ellipse is smaller than or equal to 1500μm. In some other embodiments, the minor axis of the ellipse is greater than or equal to 120μm and smaller than or equal to 200μm, and the major axis of the ellipse is smaller than or equal to 600μm. In some other embodiments, the minor axis of the ellipse is greater than or equal to 80μm and smaller than or equal to 120μm, and the major axis of the ellipse is smaller than or equal to 360μm. In some other embodiments, the minor axis of the ellipse is greater than or equal to 30μm and smaller than or equal to 80μm, and the major axis of the ellipse is smaller than or equal to 240μm. In some other embodiments, the minor axis of the ellipse is greater than or equal to 10μm and smaller than or equal to 30μm, and the major axis of the ellipse is smaller than or equal to 90μm. In some other embodiments, the minor axis of the ellipse is greater than or equal to 5μm and smaller than or equal to 10μm, and the major axis of the ellipse is smaller than or equal to 30μm.

In some embodiments, the interested region 62 has a shape of a rectangle, wherein a first side of the rectangle is smaller than or equal to a second side of the rectangle. In some embodiments, the first side of the rectangle is greater than or equal to 10000μm and smaller than or equal to 15000μm, and the second side of the rectangle is smaller than or equal to 30000μm. In some other embodiments, the first side of the rectangle is greater than or equal to 5000μm and smaller than or equal to 10000μm, and the second side of the rectangle is smaller than or equal to 20000μm. In some other embodiments, the first side of the rectangle is greater than or equal to 2000μm and smaller than or equal to 5000μm, and the second side of the rectangle is smaller than or equal to 15000μm. In some other embodiments, the first side of the rectangle is greater than or equal to 1000μm and smaller than or equal to 2000μm, and the second side of the rectangle is smaller than or equal to 6000μm. In some other embodiments, the first side of the rectangle is greater than or equal to 500μm and smaller than or equal to 1000μm, and the second side of the rectangle is smaller than or equal to 3000μm. In some other embodiments, the first side of the rectangle is greater than or equal to 200μm and smaller than or equal to 500μm, and the second side of the rectangle is smaller than or equal to 1500μm. In some other embodiments, the first side of the rectangle is greater than or equal to 120μm and smaller than or equal to 200μm, and the second side of the rectangle is smaller than or equal to 600μm. In some other embodiments, the first side of the rectangle is greater than or equal to 80μm and smaller than or equal to 120μm, and the second side of the rectangle is smaller than or equal to 360μm. In some

other embodiments, the first side of the rectangle is greater than or equal to $30\mu$m and smaller than or equal to $80\mu$m, and the second side of the rectangle is smaller than or equal to $240\mu$m. In some other embodiments, the first side of the rectangle is greater than or equal to $10\mu$m and smaller than or equal to $30\mu$m, and the second side of the rectangle is smaller than or equal to $90\mu$m. In some other embodiments, the first side of the rectangle is greater than or equal to $5\mu$m and smaller than or equal to $10\mu$m, and the second side of the rectangle is smaller than or equal to $30\mu$m.

In some embodiments, the to-be-thinned starting region 64 has a shape of a rectangle, wherein a first side of the rectangle is smaller than or equal to a second side of the rectangle. In some embodiments, the first side of the rectangle is greater than or equal to $10000\mu$m and smaller than or equal to $15000\mu$m, and the second side of the rectangle is smaller than or equal to $30000\mu$m. In some other embodiments, the first side of the rectangle is greater than or equal to $5000\mu$m and smaller than or equal to $10000\mu$m, and the second side of the rectangle is smaller than or equal to $20000\mu$m. In some other embodiments, the first side of the rectangle is greater than or equal to $2000\mu$m and smaller than or equal to $5000\mu$m, and the second side of the rectangle is smaller than or equal to $15000\mu$m. In some other embodiments, the first side of the rectangle is greater than or equal to $1000\mu$m and smaller than or equal to $2000\mu$m, and the second side of the rectangle is smaller than or equal to $6000\mu$m. In some other embodiments, the first side of the rectangle is greater than or equal to $500\mu$m and smaller than or equal to $1000\mu$m, and the second side of the rectangle is smaller than or equal to $3000\mu$m. In some other embodiments, the first side of the rectangle is greater than or equal to $200\mu$m and smaller than or equal to $500\mu$m, and the second side of the rectangle is smaller than or equal to $1500\mu$m. In some other embodiments, the first side of the rectangle is greater than or equal to $120\mu$m and smaller than or equal to $200\mu$m, and the second side of the rectangle is smaller than or equal to $600\mu$m. In some other embodiments, the first side of the rectangle is greater than or equal to $80\mu$m and smaller than or equal to $120\mu$m, and the second side of the rectangle is smaller than or equal to $360\mu$m. In some other embodiments, the first side of the rectangle is greater than or equal to $30\mu$m and smaller than or equal to $80\mu$m, and the second side of the rectangle is smaller than or equal to $240\mu$m. In some other embodiments, the first side of the rectangle is greater than or equal to $10\mu$m and smaller than or equal to $30\mu$m, and the second side of the rectangle is smaller than or equal to $90\mu$m. In some other embodiments, the first side of the rectangle is greater than or equal to $5\mu$m and smaller than or equal to $10\mu$m, and the second side of the rectangle.

In some embodiments, the interested region 62 has a shape of a polygon. In some embodiments, the interested region 62 has a shape of an L-shaped. In some embodiments, the interested region 62 has a shape of a triangle. In some embodiments, the interested region 62 has a shape of an oblong. In some embodiments, the to-be-thinned starting region 64 has a shape of a polygon. In some embodiments, the to-be-thinned starting region 64 has a shape of an L-shaped. In some embodiments, the to-be-thinned starting region 64 has a shape of a triangle. In some embodiments, the to-be-thinned starting region 64 has a shape of an oblong.

In present invention, the desired thickness D within the interested region 62 of each of the plurality of dies 61 is independent of a shape of the interested region 62 of each of the plurality of dies 61 respectively and also independent of an area of the interested region 62 of each of the plurality of dies 61 respectively.

In some embodiments, a ratio of the interested region 62 to the to-be-thinned starting region 64 (i.e. a ratio of a region occupied by the bottom surface 76 of the backside trench 75 to a region occupied by the opening 78 of the backside trench 75) is greater than or equal to 0.98 and smaller than or equal to 1; in some embodiments, the ratio is greater than or equal to 0.95 and smaller than or equal to 0.98; in some embodiments, the ratio is greater than or equal to 0.9 and smaller than or equal to 0.95; in some embodiments, the ratio is greater than or equal to 0.8 and smaller than or equal to 0.9; in some embodiments, the ratio is greater than or equal to 0.7 and smaller than or equal to 0.8; in some embodiments, the ratio is greater than or equal to 0.6 and smaller than or equal to 0.7; in some embodiments, the ratio is greater than or equal to 0.5 and smaller than or equal to 0.6.

In some embodiments, a ratio of the to-be-thinned starting region 64 of the die 61 to a region occupied by the die 61 (i.e. a ratio of a region occupied by the opening 78 of the backside trench 75 to a region occupied by the die 61) is greater than or equal to 0.95 and smaller than or equal to 0.98; in some embodiments, the ratio is greater than or equal to 0.9 and smaller than or equal to 0.95; in some embodiments, the ratio is greater than or equal to 0.85 and smaller than or equal to 0.9; in some embodiments, the ratio is greater than or equal to 0.8 and smaller than or equal to 0.85; in some embodiments, the ratio is greater than or equal to 0.7 and smaller than or equal to 0.8; in some embodiments, the ratio is greater than or equal to 0.6 and smaller than or equal to 0.7; in some embodiments, the ratio is greater than or equal to 0.5 and smaller than or equal to 0.6; in some embodiments, the ratio is greater than or equal to 0.4 and smaller than or equal to 0.5; in some embodiments, the ratio is greater than or equal to 0.3 and smaller than or equal to 0.4; in some embodiments, the ratio is greater than or equal to 0.2 and smaller than or equal to 0.3; in some embodiments, the ratio is greater than or equal to 0.1 and smaller than or equal to 0.2.

In some embodiments, the light source 32 may be other type of light source (for example, not a coaxial light source), such as a ring light source, at least one line illumination light, a surface light, a diffuse dome illumination light, or other types of light.

In some embodiments, the wafer 6 may be made of at least one material selected from the group consisting of: glass, SiC, GaN, GaN on SiC, $Ga_2O_3$, Si, GaN on Si, GaAs, sapphire, InP, GaP, AlN, ZnSe, InAs, SiGe, diamond and GaSb.

In some embodiments, the motion driving apparatus 2 further includes a rotational stage (not shown in Figure), wherein the rotational stage of the motion driving apparatus 2 is disposed on the three-axis positioning stage of the motion driving apparatus 2, and the carrying apparatus 5 is disposed on the rotational stage of the motion driving apparatus 2, wherein the wafer 6 carried by the carrying apparatus 5 can be rotated relative to the Z-axis passing through a center of the rotational stage (or passing through a center of the wafer 6) by the rotational stage.

In some embodiments, the carrying apparatus 5 is disposed on a combination of the X-axis positioning stage and the Y-axis positioning stage of the motion driving apparatus 2 (not shown in Figure), and the image capturing apparatus 3 is disposed on the Z-axis positioning stage (not shown in Figure).

In some embodiments, the motion driving apparatus 2 further includes a rotational stage (not shown in Figure), wherein rotational stage of the motion driving apparatus 2 is disposed on a combination of the X-axis positioning stage and the Y-axis positioning stage of the motion driving apparatus 2 (not shown in Figure), the carrying apparatus 5 is disposed on the rotational stage of the motion driving apparatus 2, and the image capturing apparatus 3 is disposed on the Z-axis positioning stage (not shown in Figure), wherein the wafer 6 carried by the carrying apparatus 5 can be rotated relative to the Z-axis passing through a center of the rotational stage (or passing through a center of the wafer 6) by the rotational stage.

In some embodiments, the carrying apparatus 5 is disposed on a combination of the X-axis positioning stage and the Y-axis positioning stage of the motion driving apparatus 2 (not shown in Figure), and the laser apparatus 4 is disposed on the Z-axis positioning stage (not shown in Figure).

In some embodiments, the motion driving apparatus 2 further includes a rotational stage (not shown in Figure), wherein rotational stage of the motion driving apparatus 2 is disposed on a combination of the X-axis positioning stage and the Y-axis positioning stage of the motion driving apparatus 2 (not shown in Figure), the carrying apparatus 5 is disposed on the rotational stage of the motion driving apparatus 2, the laser apparatus 4 is disposed on the Z-axis positioning stage (not shown in Figure), wherein the wafer 6 carried by the carrying apparatus 5 can be rotated relative to the Z-axis passing through a center of the rotational stage (or passing through a center of the wafer 6) by the rotational stage.

In the method for localized wafer thinning of the present invention, the Step C is executed after the Step B and before the Step F. For example, (1) the Step C is executed after the Step B, the Step D is executed after the Step C, the Step E is executed after the Step D, and the Step F is executed after the Step E; or (2) the Step D is executed after the Step B, the Step C is executed after the Step D, the Step E is executed after the Step C, and the Step F is executed after the Step E; or (3) the Step D is executed after the Step B, the Step E is executed after the Step D, the Step C is executed after the Step E, and the Step F is executed after the Step C.

The present invention further provides a wafer with locally thinned structure, which comprises a wafer 6, wherein the wafer 6 includes a plurality of dies 61, wherein each of the plurality of dies 61 includes at least one device 7 and at least one backside trench 75; wherein the at least one device 7 is formed on a top surface 60 of the wafer 6; the at least one backside trench 75 is formed by laser processing; wherein the at least one backside trench 75 has an opening 78 on a bottom surface 63 of the wafer 6; wherein in each of the plurality of dies 61, a region occupied by the opening 78 of the at least one backside trench 75 is related to the at least one device 7. The wafer warpage will not occur for the wafer 6 with locally thinned structure.

In some embodiments, in each of the plurality of dies 61, the region occupied by the opening 78 of the at least one backside trench 75 is determined according to at least one interested feature related to the at least one device 7.

In some embodiments, in each of the plurality of dies 61, the at least one interested feature is within or identical to the region occupied by the opening 78 of the at least one backside trench 75.

In some embodiments, in each of the plurality of dies 61, a region occupied by a bottom surface 76 of the at least one backside trench 75 is related to the at least one device 7.

In some embodiments, in each of the plurality of dies 61, the region occupied by the bottom surface 76 of the at least one backside trench 75 is determined according to at least one interested feature related to the at least one device 7.

In some embodiments, in each of the plurality of dies 61, the at least one interested feature is within or identical to the region occupied by the bottom surface 76 of the at least one backside trench 75.

In some embodiments, in each of the plurality of dies 61, the region occupied by the bottom surface 76 of the at least one backside trench 75 is within or identical to the region occupied by the opening 78 of the at least one backside trench 75.

In some embodiments, in each of the plurality of dies 61, the wafer 6 has a desired thickness within the region occupied by the bottom surface 76 of the at least one backside trench 75. In some embodiments, the desired thickness is greater than $10\mu m$.

In some embodiments, in each of the plurality of dies 61, the wafer 6 has a desired thickness D1 within a region occupied by a bottom surface 761 of one of the at least one backside trench 75; while the wafer has a desired thickness D2 within a region occupied by a bottom surface 762 of the other one of the at least one backside trench 75, wherein the desired thickness D1 is smaller than, equal to or greater than the desired thickness D2. In some embodiments, the desired thickness D2 is greater than 100nm.

In some embodiments, in each of the plurality of dies 61, the bottom surface 76 of the at least one backside trench 75 includes a first bottom surface 761 of the at least one backside trench 75 and a second bottom surface 762 of the at least one backside trench 75, the wafer 6 has a desired thickness D1 within a first sub-region 621 occupied by the first bottom surface 761 of the at least one backside trench 75; while the wafer 6 has a desired thickness D2 within a second sub-region 622 occupied by the second bottom surface 762 of the at least one backside trench 75, wherein the desired thickness D1 is smaller than, equal to or greater than the desired thickness D2. In some embodiments, the desired thickness D2 is greater than 100nm.

In some embodiments, in each of the plurality of dies 61, a ratio of the region occupied by the bottom surface 76 of the at least one backside trench 75 to the region occupied by the opening 78 of the at least one backside trench 75 is greater than or equal to 0.5 and smaller than or equal to 1.

In some embodiments, each of the plurality of dies 61 includes a plurality of sub-dies 691-699, each of the plurality of sub-dies 691-699 includes at least one of the at least one device 7 formed on the top surface 60 of the wafer 6.

In some embodiments, a ratio of the region occupied by the opening 78 of the at least one backside trench 75 of any one of plurality of dies 61 to a region occupied by the one of the plurality of dies 61 is smaller than or equal to 0.98.

In some embodiments, in each of the plurality of dies 61, one of the at least one backside trench 75 and the other one of the at least one backside trench 75' are adjacent; wherein a gap between a region occupied by an opening 78 of the one of the at least one backside trench 75 and a region occupied by an opening 78' of the other one of the at least one backside trench 75' is greater than or equal to 10μm.

As disclosed in the above description and attached drawings, the present invention can provide a system for localized wafer thinning and method thereof. It is new and can be put into industrial use.

Although the embodiments of the present invention have been described in detail, many modifications and variations may be made by those skilled in the art from the teachings disclosed hereinabove. Therefore, it should be understood that any modification and variation equivalent to the spirit of the present invention be regarded to fall into the scope defined by the specification of the present invention.

**Claims**

1. A method for localized wafer thinning, comprising following steps of:

   Step A: providing a wafer (6), wherein the wafer (6) includes a plurality of dies (61), each of the plurality of dies (61) includes at least one device (7) formed on a top surface (60) of the wafer (6);
   Step B: determining at least one interested feature of each of the plurality of dies (61), wherein the at least one interested feature of each of the plurality of dies (61) is related to the at least one device (7) of each of the plurality of dies (61) respectively;
   Step C: determining at least one to-be-thinned starting region (64) of each of the plurality of dies (61) according to the at least one interested feature of each of the plurality of dies (61) respectively;
   Step D: capturing at least one image of each of the plurality of dies (61) by an image capturing apparatus (3);
   Step E: performing image recognition on the at least one image to recognize the at least one interested feature of each of the plurality of dies (61) by an image recognition device (80); and
   Step F: performing localized laser thinning processing on a bottom surface (63) of the wafer (6) within the at least one to-be-thinned starting region (64) of each of the plurality of dies (61) by a laser apparatus (4), such that the wafer (6) is locally thinned within the at least one to-be-thinned starting region (64) of each of the plurality of dies (61).

2. The method for localized wafer thinning according to claim 1, further comprising a following step of: determining at least one interested region (62) of each of the plurality of dies (61) according to the at least one interested feature of each of the plurality of dies (61) respectively, wherein the at least one interested region (62) of each of the plurality of dies (61) is within or identical to the at least one to-be-thinned starting region (64) of each of the plurality of dies (61) respectively.

3. The method for localized wafer thinning according to claim 2, wherein after the Step F, at least one backside trench (75) of each of the plurality of dies (61) is formed, wherein the at least one interested region (62) of each of the plurality of dies (61) defines a region occupied by a bottom surface (76) of the at least one backside trench (75) of each of the plurality of dies (61) respectively.

4. The method for localized wafer thinning according to claim 2, wherein after the Step F, the wafer (6) has a desired thickness (D) within at least one of the at least one interested region (62) of each of the plurality of dies (61) respectively.

5. The method for localized wafer thinning according to claim 2, wherein, after the Step F, the wafer (6) has a desired thickness (D) within one of the at least one interested region (62) of each of the plurality of dies (61) respectively; while the wafer (6) has a desired thickness (D') within the other one of the at least one interested region (62') of each of the plurality of dies (61) respectively, wherein the desired thickness (D) is smaller than, equal to or greater than the desired thickness (D').

6. The method for localized wafer thinning according to claim 2, wherein the at least one interested feature of each of the plurality of dies (61) is within or identical to the at least one interested region (62) of each of the plurality of dies (61) respectively.

7. The method for localized wafer thinning according to claim 2, wherein, in each of the plurality of dies (61), the at least one interested region (62) includes a first interested sub-region (621) and a second interested sub-region (622); wherein, in each of the plurality of dies (61), after the Step F, the wafer (6) has a desired thickness (D1) within the first interested sub-region (621) of the at least one interested region (62) respectively; while the wafer (6) has a desired thickness (D2) within the second interested sub-region (622) of the at least one interested region (62) respectively, wherein the desired thickness (D1) is equal to or greater than the desired thickness (D2), wherein the desired thickness (D2) is greater than 100nm.

8. The method for localized wafer thinning according to claim 1 or 2, wherein each of the plurality of dies (61) includes a plurality of sub-dies (691-699), each of the plurality of sub-dies (691-699) includes at least one of the at least one device (7) formed on the top surface (60) of the wafer (6).

9. The method for localized wafer thinning according to claim 1 or 2, wherein the at least one interested feature of each of the plurality of dies (61) is within or identical to the at least one to-be-thinned starting region (64) of each of the plurality of dies (61) respectively.

10. The method for localized wafer thinning according to claim 1 or 2, wherein, in each of the plurality of dies (61), one of the at least one to-be-thinned starting region (64) and the other one of the at least one to-be-thinned starting region (64') are adjacent; wherein, in each of the plurality of dies (61), a gap between the one of the at least one to-be-thinned starting region (64) and the other one of the at least one to-be-thinned starting region (64') is greater than or equal to 10μm.

11. The method for localized wafer thinning according to claim 1 or 2, wherein the wafer (6) is made of at least one material selected from the group consisting of: glass, SiC, GaN, GaN on SiC, Ga2O3, Si, GaN on Si, GaAs, sapphire, InP, GaP, AlN, ZnSe, InAs, SiGe, diamond and GaSb.

12. A system for localized wafer thinning (1), comprising:

a motion driving apparatus (2);
a carrying apparatus (5) disposed on the motion driving apparatus (2), the carrying apparatus (5) is used for carrying a wafer (6), wherein the wafer (6) includes a plurality of dies (61), each of the plurality of dies (61) includes at least one device (7) formed on a top surface (60) of the wafer (6);
an image capturing apparatus (3) including an image capture device (30), wherein the motion driving apparatus (2) enables at least one of a relative displacement and a relative rotation between the image capture device (30) and the wafer (6), the image capture device (30) is used for capturing at least one image of each of the plurality of dies (61);
a controlling integration apparatus (8) connected to the motion driving apparatus (2), the carrying apparatus (5) and the image capturing apparatus (3) for controlling the motion driving apparatus (2), the carrying apparatus (5) and the image capturing apparatus (3), wherein the controlling integration apparatus (8) is used for determining at least one interested feature of each of the plurality of dies (61) and determining at least one to-be-thinned starting region (64) of each of the plurality of dies (61) according to the at least one interested feature of each of the plurality of dies (61) respectively, wherein the at least one interested feature of each of the plurality of dies (61) is related to the at least one device (7) of each of the plurality of dies (61) respectively, wherein the controlling integration apparatus (8) includes an image recognition device (80), the image recognition device (80) is used for performing image recognition on the at least one image of each of the plurality of dies (61) captured by the image capture device (30) to recognize the at least one interested feature of each of the plurality of dies (61); and
a laser apparatus (4) connected to the controlling integration apparatus (8) for being controlled by the controlling integration apparatus (8), wherein the motion driving apparatus (2) enables at least one of a relative displacement and a relative rotation between the laser apparatus (4) and the wafer (6), the laser apparatus (4) is used for performing localized laser thinning processing on a bottom surface (63) of the wafer (6) within the at least one to-be-thinned starting region (64) of each of the plurality of dies (61), such that the wafer (6) is locally thinned within the at least one to-be-thinned starting region (64) of each of the plurality of dies (61).

13. The system for localized wafer thinning (1) according to claim 12, wherein the controlling integration apparatus (8) is further used for determining at least one interested region (62) of each of the plurality of dies (61) according to the at least one interested feature of each of the plurality of dies (61) respectively, wherein the at least one interested region (62) of each of the plurality of dies (61) is within or identical to the at least one to-be-thinned starting region (64) of each of the plurality of dies (61) respectively.

14. The system for localized wafer thinning (1) according to claim 12 or 13, wherein the wafer (6) is not transparent, the top surface (60) of the wafer (6) is between the bottom surface (63) of the wafer (6) and the image capture device (30).

15. The system for localized wafer thinning (1) according to claim 12 or 13, wherein the wafer (6) is transparent, the image capturing apparatus (3) further comprises a light source (32), wherein the top surface (60) of the wafer (6) is between the bottom surface (63) of the wafer (6) and the light source (32), wherein the top surface (60) of the wafer (6) is between the bottom surface (63) of the wafer (6) and the image capture device (30) or the bottom surface (63) of the wafer (6) is between the top surface (60) of the wafer (6) and the image capture device (30).

Fig. 1

Fig. 2

Fig. 3

Fig. 4

Fig. 5

Fig. 6

Fig. 7

Fig. 8

Fig. 9

Fig. 10

Fig. 11

Fig. 12

Fig. 13

Fig. 14

Fig. 15

Fig. 16

Fig. 17

Fig. 18

Fig. 19

Fig. 20

Fig. 21

Fig. 22

72(7)  74(7)  71(7)  ‑61

D

76

Fig. 23

613(61)  612(61)  611(61)  614(61)  615(61)

7  7  7  7  7

60

D3  D2  D1  D4  D5

T

6

65  753(75)  65  752(75)  65  751(75)  65  754(75)  65  755(75)  65

63

Fig. 24

EP 4 664 511 A1

Fig. 25

Fig. 26

Fig. 27

Fig. 28

Fig. 29

Fig. 30

Fig. 31

Fig. 32

Fig. 33

## EUROPEAN SEARCH REPORT

Europäisches
Patentamt
European
Patent Office
Office européen
des brevets

**Application Number**

EP 25 17 5403

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/406601 A1 (UPPILI SUDARSAN [US] ET AL) 22 December 2022 (2022-12-22) | 1-11 | INV. H01L21/78 |
| Y | * paragraph [0006] * <br> * paragraph [0032] - paragraph [0037] * <br> * figure 2 * <br> ----- | 12-15 | H01L21/302 B23K26/03 B23K26/364 H01L21/67 |
| Y | US 2020/103220 A1 (KIMURA NOBUYUKI [JP] ET AL) 2 April 2020 (2020-04-02) <br> * paragraph [0002] * <br> * paragraph [0021] * <br> * paragraph [0032] - paragraph [0039] * <br> ----- | 12-15 | |
| A | US 2019/267344 A1 (SEDDON MICHAEL J [US] ET AL) 29 August 2019 (2019-08-29) <br> * figure 10 * <br> ----- | 1-11 | |
| A | US 2006/079011 A1 (TANDY WILLIAM D [US] ET AL) 13 April 2006 (2006-04-13) <br> * paragraph [0014] - paragraph [0033] * <br> ----- | 12-15 | |
| | | | **TECHNICAL FIELDS SEARCHED (IPC)** <br> H01L <br> B23K |

The present search report has been drawn up for all claims

| Place of search | Date of completion of the search | Examiner |
|---|---|---|
| The Hague | 8 October 2025 | Boubal, François |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 17 5403

08-10-2025

| Patent document cited in search report | Publication date | Patent family member(s) | Publication date |
|---|---|---|---|
| US 2022406601 A1 | 22-12-2022 | CN 114985948 A | 02-09-2022 |
| | | US 2022406601 A1 | 22-12-2022 |
| US 2020103220 A1 | 02-04-2020 | CN 110966944 A | 07-04-2020 |
| | | DE 102019214896 A1 | 02-04-2020 |
| | | JP 7103906 B2 | 20-07-2022 |
| | | JP 2020056579 A | 09-04-2020 |
| | | KR 20200036739 A | 07-04-2020 |
| | | TW 202013358 A | 01-04-2020 |
| | | US 2020103220 A1 | 02-04-2020 |
| US 2019267344 A1 | 29-08-2019 | CN 110190041 A | 30-08-2019 |
| | | CN 120089649 A | 03-06-2025 |
| | | JP 7353770 B2 | 02-10-2023 |
| | | JP 2019169704 A | 03-10-2019 |
| | | JP 2023179516 A | 19-12-2023 |
| | | TW 201937674 A | 16-09-2019 |
| | | TW 202331974 A | 01-08-2023 |
| | | US 2019267344 A1 | 29-08-2019 |
| | | US 2021272920 A1 | 02-09-2021 |
| US 2006079011 A1 | 13-04-2006 | US 6524881 B1 | 25-02-2003 |
| | | US 2002096491 A1 | 25-07-2002 |
| | | US 2002098608 A1 | 25-07-2002 |
| | | US 2003003688 A1 | 02-01-2003 |
| | | US 2004161876 A1 | 19-08-2004 |
| | | US 2006079011 A1 | 13-04-2006 |

EPO FORM P0459